(19) Europäisches Patentamt
European Patent Office
Office européen des brevets

(11) **EP 1 598 750 A1**

(12) **EUROPEAN PATENT APPLICATION**
published in accordance with Art. 158(3) EPC

(43) Date of publication:
**23.11.2005 Bulletin 2005/47**

(21) Application number: **04705179.2**

(22) Date of filing: **26.01.2004**

(51) Int Cl.[7]: **G06F 17/10**, G06F 17/50

(86) International application number:
**PCT/JP2004/000640**

(87) International publication number:
**WO 2004/068364 (12.08.2004 Gazette 2004/33)**

(84) Designated Contracting States:
**AT BE BG CH CY CZ DE DK EE ES FI FR GB GR HU IE IT LI LU MC NL PT RO SE SI SK TR**
Designated Extension States:
**AL LT LV MK**

(30) Priority: **27.01.2003 JP 2003017612**

(71) Applicant: **Mathematec Kabushiki Kaisha**
**Tokyo 103-0027 (JP)**

(72) Inventor: **WATARI, Masao,**
**Mathematec Kabushiki Kaisha**
**Tokyo 1160014 (JP)**

(74) Representative: **Goddar, Heinz J.**
**FORRESTER & BOEHMERT**
**Pettenkoferstrasse 20-22**
**80336 München (DE)**

# (54) CALCULATION PROCESSING DEVICE, CALCULATION PROCESSING DEVICE DESIGN METHOD, AND LOGIC CIRCUIT DESIGN METHOD

(57) An operation device having the element number and delay time of the operation circuitry reduced is realized by a purely logical approach. An operation method based on encoding is concretely and efficiently logic-designed to provide an encoding operation device. operators of an operation system are extended if required to treat as logic functions with the base number r. When r=2, using a generating function as a new representation of a mapping, a new operation system is logic-designed under encoding conditions and logic expression simplifying conditions, or the new operation system is logic-designed by matching the topologies of input/output relation of the operators of the original operation system and the new operation system. The operation device satisfying the encoding conditions and logic expression simplifying conditions achieves speeding up and low power consumption.

FIG.3

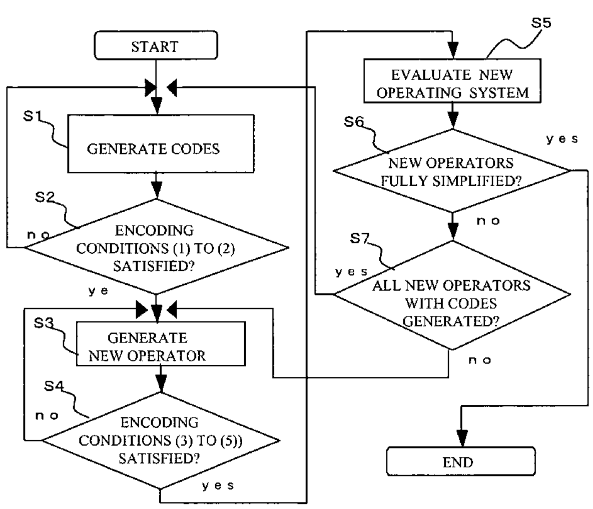


EP 1 598 750 A1

## Description

### Technical Field

This invention relates to operation technology, and more particularly to an encoding based operation principle achieving speed up, low power consumption and the like of operation LSI's and similar circuits, a method of designing encoding therefore, and an operation device.

### Background Art

Operation LSI's are recently used in a very broad range of fields such as image compression/decompression, computer graphics, image recognition, speech recognition. For example, image compression/decompression of the MPEG2 or MPEG4 type needs a great number of operations and a processing unit holds a main part of the LSI.

Beside the image processing, there is increasing demand in scale of arithmetic operation of a computer, and an unlimited need for speedup still remains. Because on/off switching of transistors frequently occurs within a operating device, power consumption is also a very serious problem.

To meet such needs, some approaches of improvement in fine fabrication technology and device properties have advanced. In addition to such device technology oriented approaches, other approaches still exist.

Among approaches directed to a processing device itself, the inventor proposed "Fast Operation Method" as a method of improving the performance such as speed up thereof using a purely logical approach (International Publication 91/10186, or Japanese Laid Open Patent Application H03-201114, which is hereinafter referred as to the related patent document.)

That proposal is outlined below using the same notation as in the related document.

P binary operations $A_p:\Omega\times\Omega\rightarrow\Omega(p=1,2,\cdots,P)$ and Q unary operations $B_q:\Omega\rightarrow\Omega(q=1,2,\cdots,Q)$ are defined. Consider a finite set closing with those operations, $\Omega$. The combination of $\Omega$, $A_p$, $B_q$ is referred to as an old operation system $(\Omega,A_p,B_q)$. Instead of performing the operations $A_p$, $B_q$ of the old operation system, data on the set $\Omega$ is converted to data in a set defined as $|\Omega'|\geq|\Omega|(|\Omega'|,|\Omega|$ are element numbers or cardinal numbers of $\Omega',\Omega$ respectively) by an encoder $\Phi:\Omega\rightarrow\Omega'$, and then operations $A'_p:\Omega'\times\Omega'\rightarrow\Omega'$ and $B'_q:\Omega'\rightarrow\Omega'$ defied on $\Omega'$ corresponding to the operations $A_p$, $B_q$ are performed, the operation output obtained as data on $\Omega'$ is converted by a decoder $\Psi:\Omega'\rightarrow\Omega$, to obtain the corresponding result on $\Omega$, which is intended to obtain. Hereinafter, the combination of $\Omega',A'_p,B'_q,\Phi,\Psi$ is referred to as a new operation system. In this operation principle, by imposing the following four expressions (1), (2) , (3) and (4) among the old and new operation systems, encoding conditions are satisfied, which make it sure that an operation result with the old system and a operation result with the new system coincide with to each other.

$$\Phi(X)\in[X]\subset\Omega' \text{ (for } \forall X\in\Omega) \quad (1)$$

$$\Psi([X])=X\in\Omega' \text{ (for } \forall X\in\Omega) \quad (2)$$

$$Z=A_p(X,Y)\Leftrightarrow[Z]\supset A'_p([X],[Y]) \text{ (for } \forall X,Y,Z\in\Omega\text{, every p)} \quad (3)$$

$$Y=B_q(X)\Leftrightarrow[Y]\supset B'_q([X]) \text{ (for } \forall X,Y\in\Omega\text{, every q)} \quad (4)$$

Note that [X] is a subset on $\Omega'$ corresponding to any element X on $\Omega$. A family of sets $\{[X]\}_{X\in\Omega}$ is referred to as codes, and

$$C=\bigcup_{X\in\Omega}[X]$$

is a universal set of the codes, and $N_C=\Omega'-C$ is a set of non-codes.

From (1) and (2)

$$[X] \neq \varphi (\varphi\text{:empty set}) \quad (5)$$

$$X \neq Y \Leftrightarrow [X] \cap [Y] = \varphi \quad (6)$$

are satisfied.

It is the related document that proposed to determine the designs of the encoder, decoder and new operation unit by using a computer so as to meet the encoding conditions (1) to (4) and to simplify the new operation unit, and then achieve the speedup and other efficiencies.

That proposal was aimed not only to the four operations that is addition, subtraction, multiplication, division, but also to general operations and mapping broadly, but it has the following six types of problems.

i) Because the sets of data in the old operation system and the new operation system are conventional finite sets Ω, Ω', the mappings representing the operators, encoder and decoder are conventional mappings, and then their relation with logic expressions are not clear.

ii) Because the old operation system is intended for an operation system closing with Ω, general operations can not be applied to.

iii) Because the relational expressions of the encoding is expressed by the general mappings and sets, what the satisfaction of the relation logically means is not comprehensible, and then it is some times difficult to derive the actual logical expressions which meet the relational expression.

iv) It failed in formulating the conditions of simplified circuitry.

v) Examples of encoding are disclosed only for non-redundant codes.

vi) It failed in concrete implementation of system configurations as encoding operation systems.

## Disclosure of the Invention

In view of the foregoing, it is an object of the invention to resolve the problems of the prior art of the related document, and is in particular to enable concrete logic designs with r-value logic by extending a given operation if required to express the multiple inputs and multiple outputs of all of the operators, encoder, and decoder of the old and new operation systems using the r-value expression; to enable efficient logic designs of the new operation system which meets encoding conditions by using new expression for Boolean logic expression; and to enable an encoding operation device which can be implemented with an LSI by providing circuit designs based on a encoding operation method which reduces the circuit scale and operation delay time.

Various aspects of the invention attaining the above object are described in the attached claims.

Those aspects of the invention are described below.

(1) First aspect of the invention

According the first aspect of the invention, to resolve the problems i) and ii) of the related document, operators (or an operator) of a given operation system (herein after referred to as an original operation system), are, if required, extended to mappings of an r-value logic type to form operators of an old operation system closing with operations; all of the encoder, decoder and operators of a new operation system are treated as mappings of an r-value logic type; and the new operation system with the r-value logic is logic-designed such that the encoding conditions described in the related document, encoding conditions having expressed in an equation form by characteristic logic functions, or a condition that the input/output topologies of the operators of the original operation system and the new operation system are same as each other is satisfied.

(2) Second aspect of the invention

According to the second aspect of the invention, the characteristic functions of sets are treated as binary logic functions, and a newly invented generating function is introduced, which is a expression method for mappings, to process the relationship among characteristic functions, composition of mappings, and the like efficiently and comprehensibly, and further various relation expression are derived to design logic circuits.

(3) Third aspect of the invention

According to the third aspect of the invention, the simplicity of a logic function is treated as an expression of variable dependency to design logic circuits having a simplified configuration.
The second and third aspects of the invention can be applied in combination.

(4) Fourth aspect of the invention

According to the fourth aspect of the invention, to resolve the problem iii) of the related document, all of the operators of the old operation system and the encoder, decoder and operator of the new operation system are treated as binary logic functions, and they are expressed by the generating functions, and the encoding conditions expressed by the generating functions are derived to enable logic design of the new operation system comprehensibly and efficiently.

(5) Fifth aspect of the invention

According to the fifth aspect of the invention, to resolve the problem iv) of the related document, conditions for simplifying the new operation system is provided in an equation form, and they are used together with the encoding conditions of the second aspect of the invention to enable the logic design of the new operation system satisfying the conditions for the simplification.

(6) Sixth aspect of the invention

According to the sixth aspect of the invention, to resolve the both of the problems iii) and iv) of the related document, an encoder is limited to an isomorphic mapping, subject to the second to fourth aspects of the invention, to enable logic design of the new operation system satisfying the encoding conditions and simplification conditions.
The technique according to the second aspect of the invention is not limited to the encoding operation method, and broadly applied to logic design and logic analysis.
Exemplified configurations for resolving the problem v) of the related document is shown in the embodiments designed in the basis of the encoding operation method and design method in accordance to the various aspects.

[notation]

The invention is described in details below. For preparation, we use the following notation.
Let $B_r$ be an r-value set; $B_r^n$ (a direct product of n units of $B_r$) be a set of number representations having the base number r and word length n. For two-value, $B$ is used where $B_2 = B = \{0.1\}$. An element of $B_r$ is a scalar, and is written by lower letters $x,y,\cdots$ such as $x,y,\cdots \in B_r$. An element of $B_r^n$ is a vector having n components, is denoted by upper letters such as $X,Y,\cdots \in B_r^n$. (For example, $X=(x_1,x_2,\cdots,x_n)$).
Let n-variable logic function to be a scalar function. It is written by $f(X)=f(x_1,x_2,\cdots,x_n)$ with the lower letter $f$. It is also considered as a mapping such as $f$: $B_r^n \to B_r$, and the same symbol is used.
When m units of n-variable r-value logic functions $f_j(X)(j=1,2,\cdots,m)$ are treated collectively as a vector function, the vector function is denoted by a upper letter such as $F$ for $F(X)=(f_1(X),f_2(X),\cdots,f_m(X))$. The vector function is considered as a mapping such as $F : B_r^n \to B_r^m$. The same notation is used.
For two-value, the negation of a variable ( or constant) is written by "$\bar{x}$", the logical product ( and ) of two variables ( or constant) $x,y$ is written by "$x \cdot y$" or "$xy$", the logical sum ( or ) of $x,y$ is written by "$x \cup y$", the logical product of n variables (constants) $x_i(i=1,2,\cdots,n)$ is written by

$$\bigcap_i x_i \ ,$$

and the logical sum is written by

$$\bigcup_{i} x_i \ .$$

Without the range of i specified, a product or a sum for all.

Likewise, for example, if $X \in B^n$, then

$$\bigcap_{X} f(X)$$

means a product for all of $B^n$. A sum is the same.

The sum (exor) of the Boolean rings of two variables (or constants) $x,y$ is written by $x+y$, the range of the sum being the same as described above.

Let $x^a$ be what satisfies $x^a=x$ at $a$=1 and $x^a=\bar{x}$ at $a$=0. It is written by $x^a = xa \cup \overline{xa}$ . Then, for $X,A \in B^n$ ,

$$X^A = \bigcap_{i=1}^{n} x_i^{a_i} = \bigcap_{i=1}^{n} (x_i \cdot a_i \cup \overline{x_i} \cdot \overline{a_i})$$

is defined. The miniterm composed of n variables $x_1,x_2,\cdots,x_n$ is written by $X^A$ ($X,A \in B^n$). For n=3, if $A$=(0,1,0), then $X^A=\overline{x_1} \cdot x_2 \cdot \overline{x_3}$. You can correspond

$$X^A \text{は} \ \overline{x_1} \cdot x_2 \cdot \overline{x_3}$$

to the numbers $A=0,1,\cdots,7$, and then the miniterm is written briefly.

With $X^A$, the disjunctive normal form of Boolean function $f(X)$ is written by

$$f(X) = \bigcup_{A} f(A) \cdot X^A \ .$$

Boolean derivation of 2-value logic function $f(X)$ with a variable $x_i$ is the sum of Boolean rings of equations of $f(X)$ with 0,1 inserted as $x_i$, and expressed by the following equations.

$$\frac{df(X)}{dx_i} = f(x_0,x_1,\cdots,0,\cdots,x_n) + f(x_0,x_1,\cdots,1,\cdots,x_n)$$

When $\frac{df(X)}{dx_i}=0$, the function $f(X)$ is independent with the variable $x_i$.

We have generally the following equation.

$$a_i = 0 \Leftrightarrow \bigcup_{i} a_i = 0 \ , \quad f(X) = 0 \Leftrightarrow \bigcup_{X} f(X) = 0$$

We also use $\cup,\cap$ for the union and intersection of sets as conventionally because there would be no confusion.

[Configuration of the Invention]

The invention is described in details below.

[First aspect of the Invention]

The first aspect of the invention corresponds to the inventions of Claim 1 to 4.

The invention is not limited to a finite set $\Omega$ on which a closed operation system is defined as described in the related document. It can be applied to the case in which the set of input data of an operation $\Omega_{in}$ is not equal to the set of output space of the operation $\Omega out$, $\Omega_{in}\neq\Omega out$.

In particular, let Q unary operations be $G^q:\Omega_G{}^q in\rightarrow\Omega_G{}^q out(q=1,2,\cdots,Q,)$, P binary operations be $F^p$: $\Omega_F{}^p in\times\Omega_F{}^p in\rightarrow\Omega_F{}^p out$ $(p=1,2,\cdots,P)$, and S T-nary operations be $H^s:\Omega_H{}^s in\times\Omega_H{}^s in\times\cdots\times\Omega_H{}^s in\rightarrow\Omega_H{}^s out(s=1,2,\cdots,S)$. Let define an encoding operation method for an operation system ( original operation system) in which one or plural (Q+P+S>=1) operations are defined. We consider a set $B_r^n$ of number representations having the base number r and the word length n which satisfies $\max\{|\Omega_G{}^q in|,|\Omega_F{}^p in|,|\Omega_H{}^s in|,|\Omega_G{}^q out|,|\Omega_H{}^s out|\}\leq r^n$ for the maximum number among the cardinal numbers $|\Omega_G{}^q in|$, $|\Omega_F{}^p in|$, $|\Omega_H{}^s in|$, $|\Omega_G{}^q out|$, $|\Omega_F{}^p out|$, $|\Omega_H{}^s out|$... of the finite sets $\Omega_G{}^q in, \Omega_F{}^p in, \Omega_H{}^s in$ of the respective input spaces, and the finite sets $\Omega_G{}^q out, \Omega_F{}^p out, \Omega_H{}^s out$... of the respective output spaces. We consider the set $B_r{}^n$ as the set of old representation data of the old operation system, and, unless $|\Omega in|=r^n$ where $|\Omega in|$ is the cardinal number of a data set of the input space of each operation (original operation) of the original operation system, $\Omega in$ ( arbitrary one of $\Omega_G{}^q in,\Omega_F{}^p in,\Omega_H{}^s in$), add relationships corresponding to $r^n$-$|\Omega|$ unfixed elements to the corresponding original operation so that all of the original operations are extended as operations on $B_r^n$.

When the original operation system includes Q unary operations, they are extended to and treated as $G^q{}_O$: $B_r^n\rightarrow B_r^n$ $(q=1,2,\cdots,Q)$. When it includes P binary operations, they are extended to and treated as $F^p{}_O:B_r^n\times B_r^n\rightarrow B_r^n$ $(p=1,2,\cdots,P)$. Also, when it includes S T-nary operations, they are extended to and treated as $H^s{}_O:B_r^n\times B_r^n\times\cdots\times B_r^n\rightarrow B_r^n$ (T direct products of $B_r^n$, $s=1,2,\cdots,S$). Hereinafter, $B_r^n,G^q{}_O,F^p{}_O,H^s{}_O$ are referred to as the old operation system collectively.

We further consider data on a set $B_r^m(m\geq n)$ as new representation data. An encoder is an injective mapping $\Phi : B_r^n \rightarrow B_r^m$; a decoder is a surjection mapping $\Psi : B_r^m \rightarrow B_r^n$; the operator of the new operation system corresponding to $G^q{}_O$ is a unary operation $G^q{}_N$: $B_r^m \rightarrow B_r^m$; the operator of the new operation system corresponding to $F^p{}_O$ is a binary operation $F^p{}_N$: $B_r^m \times B_r^m \rightarrow B_r^m$ ; and the operator of the new operation system corresponding to $H^s{}_O$ is a T-nary operation $H^s{}_N$: $B_r^m\times B_r^m\times\cdots\times B_r^m\rightarrow B_r^m$. Thus, all the operations of the old operation system and all the operations, the encoder and the decoder of the new operation system can be related to r-value functions (r-value logic circuits) having plural inputs and plural outputs. By imposing following encoding conditions corresponding to the related document, the new operation system can be designed as particular r-value logic functions (logic circuits). The encoding conditions mean the same as described in the related document.

$$(1)\ \Phi(X)\in[X]\subset B_r{}^m\ (\text{for } \forall X\in B_r{}^n)$$

$$(2)\ \Psi([X])=X\ (\text{for } \forall X\in B_r{}^n)$$

$$(3)\ Y=G^q{}_O(X)\Leftrightarrow[Y]\supset G^q{}_N([X])\ (\text{for } \forall X,Y\in B_r{}^n,\ \forall q)$$

$$(4)\ Z=F^p{}_O(X,Y)\Leftrightarrow[Z]\supset F^p{}_N([X],[Y])\ (\text{for } \forall X,Y,Z\in B_r{}^n,\ \forall p)$$

$$(5)\ Y=H_O^s(X_1,\cdots,X_T)\Leftrightarrow[Y]\supset H_N^s([X_1],\cdots,[X_T])$$

(for $\forall X_1,\cdots,X_T,Y\in B_r^n$, $\forall s$)

Here, [X] is a subset on $B_r^m$ corresponding to on an arbitrary X on $B_r^n$; a family of sets

$$\{[X]\}_{X\in B_r^n}$$

is called a code like in the related document;

$$C=\bigcup_{X\in\Omega}[X]$$

is a universal set of the codes; and $N_C = B_r^m\text{-}C$ is a set of non-codes. Fig. 1 is a conceptual illustration of the encoding of the present invention, wherein an element X of the old representation data set $B_r^n$ is converted to data $\Phi(X)$ on the new representation data set $B_r^m$ by the encoder, and the code [X] corresponding to the old representation data $X$ is converted to $X$ by the decoder $\Psi : B_r^m \to B_r^m$ $\Phi : B_r^n \to B_r^m$. Fig. 2 is a conceptual illustration of the extension from the original operation system to the old operation system , wherein the representation space of input/output data of the original operation system is extended onto $B_r^n$ when that space does not coincide with the $B_r^n$. In particular, one unary operation G of the original operation system is extended onto the old operation Go of the old operation system.

Fig.3 is a flow chart illustrating how to determine the new operation, wherein the original operation system is extended onto the old operation system, and thereafter the new operation system is determined therefrom. The flow of Fig.3 is as follows:

[Step S1]: A code is generated.
[Step S2]: The encoding conditions (1) and (2) are checked. If the encoding conditions (1) and (2) are not satisfied, the process is returned to the step S1, andcontinues. If the encoding conditions (1) and (2) are satisfied, then the process advances to the step S3.
[Step S3]: New operators are generated.
[Step S4]: The encoding conditions (3) and (4) are checked. If the encoding conditions (3) and (4) are not satisfied, the process is returned to the step S3, and continues. If the encoding conditions (3) and (4) are satisfied, then the process advances to the step S5.
[Step S5]: The new operation system is evaluated.
[Step S6]: The simplification of the new operators is checked. If the simplification is enough, then the process is terminated. If it is not enough, then the process advances to the step S7.
[Step S7]: Whether or not all the new operators within the codes were generated is checked. If one or more remain not generated, the process returns to the step S3, and otherwise returns to the step S1 and continues.

The particular example of the process illustrated in Fig.3 is described with reference to the embodiments later.

It should be understood that some other determination flows can be adopted as described with the embodiments later.

The code and the new operators are determined by the determination flow illustrated above, and a operation device is configured with them as shown in Fig.4. In Fig.4, an operation device 100 comprising an operation unit 101, an encoder 102, a decoder 103, and a transmission path 104. The operation unit 101 is implemented with the configuration of the above mentioned new operators. The encoder 102 and the decoder 103 are implemented so to provide encoding and decoding of the code. The transmission path 104 performs data transmission between the operation unit 101 and the encoder 102 and data transmission between the operation unit 101 and the decoder 103 and the like, which can be composed of the internal bus, external bus of an LSI, communication lines and the like.

The above mentioned $F^p_O$ corresponds to what is resulted from the extension of $A_p$ of the related document, and the above mentioned $G^q{}_O$ corresponds to what is resulted from the extension of $B_q$ of the related document. Hereinafter, $B^n_r, G^q{}_N, F^p{}_N, H^s{}_N, \Phi, \Psi$ are collectively referred to as a new operation sytem.

If the new representation data set $\Omega'$ described in the related document would remain not in the form of $B^m_r$ butinageneral set form, the new operation system would need to be processed in a general mapping form as in the related document. According to the present invention, the new representation data set is restricted to the form of $B^m_r$ so that the operators of the old operation system and all of the new operation system are related to r-value logical circuits. Thus, the new operation system can be determined as mappings having an r-value logic expression by search using a computer and the like method.

Generally, there are a tremendous number of new operation systems. One new operation system obtained by the search and the like is evaluated, and when it does not meet the evaluation, another is generated by the search for the evaluation. The generation and evaluation are repeated to determine the new operation system achieving the object. Since the finally obtained new operation system corresponds to the r-value logic circuits, the r-value logic circuit can be designed by conventional logic designs.

The r-value logic wherein r-value is not 2-value is described in details for example in "Multiple Value Information Processing: Post Binary electronics", Shokosha, HIGUCHI Tatsuo, KAMEYAMA Mitsutaka.

By the way, the conditions (1) to (5) are set-theoretic expressions (relation expressions written with symbols such as $\subset$,$\Leftrightarrow$). Generally, from the definition of the characteristic function $\chi_A(X)$ of the set, $\chi_A(X)=1(for \forall X \in B) \Leftrightarrow B \subset A$. Accordingly, the conditions (1) to (5) can be written in the form of the equation of the equivalent characteristic function. To indicate that the equivalent expressions to the conditions (1) to (5) are such as the equations of characteristic functions, "c" is suffixed with the equation number like (1c) to (5c). The equivalent expressions are follows.

$$(1c)\ \chi'_{[X]}(\Phi(X)) = 1 (\text{for } \forall X \in B_r{}^n)$$

$$(2c)\ \chi_X(\Psi([X])) = 1 (\text{for } \forall X \in B_r{}^n)$$

$$(3c)\ \chi'_{[G^q{}_{O(X)}]}(G^q{}_N([X])) = 1\ (\text{for } \forall X \in B_r{}^n,\ \forall q)$$

$$(4c)\ \chi'_{[F^p{}_{O(X,Y)}]}(F^p{}_N([X],[Y]) = 1\ (\text{for } \forall X, Y \in B_r{}^n,\ \forall p)$$

$$(5c)\ \chi'_{[H^s{}_{O(X_1,\cdots,X_T)}]}(H^s{}_N([X_1],\cdots,[X_T]) = 1\ (\text{for } \forall X_1,\cdots,X_T \in B_r{}^n,\ \forall s)$$

$\chi_A(X)$ is a characteristic function of a subset $A$ of $B^n_r$ and $X \in B^n_r$ ; and $\chi'_{A'}(X')$ is a characteristic function of a subset $A'$ of $B^m_r$ and $X' \in B^m_r$.

When the expressions (1c) to (5c) are used for the encoding conditions, then whether or not a new operation system satisfies the encoding conditions for an old operation system is reduced to whether or not the characteristic function are "1". This is very beneficial in the determination using a computer.

Under the encoding conditions (1) to (5) or (1c) to (5c), a qualified new operation system can be designed, as logic circuits corresponding to r-value logic circuits, from the information of each operator ( original operator) of the known original operation system. A new encoding operation method can be provided which makes sure that the operation result using the logic-designed new operation system is the same as the operation result by the original operation system.

When it is designed with r=2, the values of characteristic functions are 0, 1, and $X \in B^n$, thus a characteristic function can be treated as one $n$-variable binary logic function. From that point, (1c) to (5c) can be expressed in a clear equation form having equivalent binary logic functions as described with reference to the third aspect of the invention.

[Second aspect of the invention]

The second aspect of the invention corresponds to Claims 5 and 6.

The following two are postulates of the aspect:

(6) Characteristic functions of sets on $B^n$ are treated as logic functions.
(7) One element of a set on $B^n$ is related to one miniterm.

Hereinafter, a characteristic function expressed in a binary logic function is called a characteristic logic function.

In particular, let the characteristic logic function of a subset $S(S \subset B^n)$ of $B^n$ be expressed as $\chi_S(X)(X \in B^n)$; let the characteristic function of a subset $T(T \subset B^m)$ of $B^m$ be expressed as $\chi'_T(Y)(Y \in B^m)$; and the image of a subset $S$ of $B^n$ with a mapping $F:B^n \rightarrow B^m$ be expressed as $F(S)$. Then, $\chi'_{F(S)}(Y)=1$ ( on $Y \in F(S)$),$\chi'_{F(S)}=0$ ( on $Y \notin F(S)$).

Thus, let the characteristic logic function of one element set having one miniterm for one element $Q$ $(=(q_1,q_2,\cdots,q_n))$ on $B^n$ be expressed as $\chi_Q(X)$. This becomes "1" only when $X=Q$, and thus $\chi_Q(X)=X^Q$ is satisfied. Miniterms are separable ($X^{Q1} \cdot X^{Q2} = 0$ (on $Q1 \neq Q2$)), then the following is clearly satisfied:

$$(8) \quad \chi_S(X) = \bigcup_{Q \in S} \chi_Q(X) = \bigcup_{Q \in S} X^Q$$

Likewise, considering one element P on $B^m$, the following is satisfied:

$$(8-1) \quad \chi'_{F(S)}(Y) = \bigcup_{P \in F(S)} \chi'_P(Y) = \bigcup_{P \in F(S)} Y^P$$

Considering that the area where $P$ moves all over $F(S)$ is completely the same as the area where $P$ moves while $Q$ moves all over $S$ with $P=F(Q)$, the equation (8-1) is reduced to the following:

$$(9) \quad \chi'_{F(S)}(Y) = \bigcup_{Q \in S} Y^{F(Q)}$$

Sum over a range restricted with $S$ is clearly equal to sum of all after multiplied by $\chi_S(X)$, from the properties of the characteristic function. Thus the following is satisfied:

$$(10) \quad \chi'_{F(S)}(Y) = \bigcup_{X} Y^{F(X)} \cdot \chi_S(X)$$

Also, for a characteristic logic function of subsets $S,T \subset B^n$ of $B^n$, the following are clearly satisfied:

$$(11) \quad \chi_S(X) \cdot \chi_T(X)=0 \ (\textit{for}\ \forall X \in B^n) \Leftrightarrow S \cap T=\phi$$

$$(12) \quad \chi_{S \cap T}(X)=\chi_S(S) \cdot \chi_T(X)$$

$$(13) \quad \chi_{S \cup T}(X)=\chi_S(S) \cup \chi_T(X)$$

$$(14) \quad \overline{\chi_S(X)} \cdot \chi_T(X)=0 \ (\textit{for}\ \forall X \in B^n) \Leftrightarrow S \supset T$$

The aforementioned configuration enables to treat characteristic functions of sets logically, and the expressions (8) to (14) can be used for set operation of general sets on $B^n$.

Further, let consider mappings $F : B^n \rightarrow B^m$, $G : B^m \rightarrow B^l$. Let a composite mapping of $F,G$ be $R : B^n \rightarrow B^l$. When a logic function is expressed in vector, the relationship of $R(X)=G(F(X))$ is satisfied. When the characteristic logic functions of a subset $U$ ( $U \subset B^l$) of $B^l$ is expressed by $\chi''_U(Z)(Z \in B^l)$, as with the above mentioned expression (10), thefollowingexpressionaresatisfied:

$$(10\text{-}1) \quad \chi''_{R(S)}(Z) = \bigcup_X Z^{R(X)} \cdot \chi_S(X)$$

$$(10\text{-}2) \quad \chi''_{G(T)}(Z) = \bigcup_Y Z^{G(Y)} \cdot \chi'_T(Y)$$

Here, let $T=F(S)$. Because of $G(F(S))=R(S)$, (10) , (10-1), (10-2) lead to the following expression:

$$(10\text{-}3) \quad \bigcup_X Z^{R(X)} \cdot \chi_S(X) = \bigcup_X (\bigcup_Y Z^{G(Y)} \cdot Y^{F(X)}) \cdot \chi_S(X)$$

And that is satisfied for an arbitrary subset $S$, and then the following is satisfied:

$$(15) \quad Z^{R(X)} = \bigcup_Y Z^{G(Y)} \cdot Y^{F(X)}$$

By the way, $Y^{F(X)}$ for a mapping $F{:}B^n \rightarrow B^m$ is a binary logic function of $Y,X$ . Thus, $Y^{F(X)}$ is a Boolean Matrix of $2^m \times 2^n$ where $2^m$ types of $Y$ are row variables (row numbers) and $2^n$ types of $X$ are column variables (column numbers).

The expression (15) means that the matrix $Z^{R(X)}$ corresponding to the composite mapping $R$ is obtained by product operation of the matrix $Y^{F(X)}$ corresponding to the mapping $F$ and the matrix $Z^{G(Y)}$ corresponding to the mapping $G$ as matrices. In order to express explicitly that $Y^{F(X)}$ is in a matrix representation, upper letters are used and the notation such as $\tilde{F}(Y,X)$ is used. Hereinafter that is referred to as a generating function of a mapping $F$. Thus the following is satisfied:

$$(16) \quad \tilde{F}(Y,X) = Y^{F(X)} = \bigcap_{j=1}^{m} \{y_j \cdot f_j(X) \cup \overline{y_j} \cdot \overline{f_j(X)}\}$$

The expression (15) is converted in a form using the generating function as follows:

$$(17) \quad \tilde{R}(Z,X) = \bigcup_Y \tilde{G}(Z,Y) \cdot \tilde{F}(Y,X)$$

From the disjunctive normal form of the logic function for an arbitrary function *g(Y)* of *Y*, and the expression (16), the following is derived:

$$(18) \quad \bigcup_Y g(Y) \cdot \tilde{F}(Y,X) = g(F(X))$$

For an identity transformation $I : B^n \rightarrow B^n$, the following is satisfied:

$$(19)\quad \bigcup_{Y} g(Y)\cdot \tilde{I}(Y,X)=g(X)$$

Thus the following relation expressions among component functions of a mapping *F* and a generating function are satisfied:

$$(20)\quad f_j(X)=\bigcup_{Y} y_j\cdot \tilde{F}(Y,X)$$

$$(21)\quad \overline{f_j(X)}=\bigcup_{Y} \overline{y_j}\cdot \tilde{F}(Y,X)$$

Let $\Omega=B^n$, then the following expressions are derived:

$$(22)\quad \bigcup_{Y} \tilde{F}(Y,X)=\chi_{\Omega}(X)=1$$

$$(23)\quad \bigcup_{X} \tilde{F}(Y,X)=\chi'_{F(\Omega)}(Y)$$

The expressions (22) and (23) express the characteristic function (=1) of the definition domain of a mapping *F*, and the characteristic function of the value range of the mapping *F* respectively. It is clearly understood from the expressions (17) to (23) that a generating function is a very important expression for deriving the basic properties of a mapping with simple operations.

Further, for an isomorphic mapping $\Phi:\Omega\rightarrow\Omega$, let define an inverse mapping $\Phi^{-1}: \Omega\rightarrow\Omega$. Then, the following is satisfied:

$$(24)\quad \tilde{\Phi}^{-1}(X,Y)=\tilde{\Phi}(Y,X)\ (\text{for } \forall X,Y\in\Omega)$$

The expression (24 and (20) lead to the following:

$$(25)\quad \phi^{-1}{}_i(X)=\bigcup_{Y} y_i\cdot \tilde{\Phi}(X,Y)$$

This expression enables directly to obtain the component functions of an inverse mapping from a generating function of an isomorphic mapping. This is clearly understood because an isomorphic mapping is bijection and has one to one correspondence.

Thus, defining an identity transformation $I:\Omega\rightarrow\Omega$ on $\Omega=B^n$, for $\Phi^{-1}\Phi=\Phi\Phi^{-1}=I$, the following is satisfied:

$$(26)\quad \bigcup_{Z}\tilde{\Phi}^{-1}(X,Z)\cdot\tilde{\Phi}(Z,Y)=\bigcup_{Z}\tilde{\Phi}(X,Z)\cdot\tilde{\Phi}(Z,Y)=\tilde{I}(X,Y)\ (\text{for}\ \ \forall X,Y,Z\in\Omega)$$

Also, for a generating function of a mapping $F : B^n \to B^m$, the following is satisfied:

$$(27)\quad \tilde{F}(Y,X)\cdot\tilde{F}(Z,X)=\tilde{F}(Y,X)\cdot\tilde{I}(Y,Z)\ (\text{ここに}\ Y,Z\in B^m)$$

This is derived from (16) as follows:

$$\tilde{F}(Y,X)\cdot\tilde{F}(Z,X)=\bigcap_{j=1}^{m}(y_j f_j(X)\cup\overline{y_j}\cdot\overline{f_j(X)})\cdot(z_j f_j(X)\cup\overline{z_j}\cdot\overline{f_j(X)})$$

$$=\bigcap_{j=1}^{m}(y_j z_j f_j(X)\cup\overline{y_j}\cdot\overline{z_j}\cdot\overline{f_j(X)})=\bigcap_{j}(y_j f_j(X)\cup\overline{y_j}\cdot\overline{f_j(X)})\cdot(y_j z_j\cup\overline{y_j}\cdot\overline{z_j})$$

$$=\tilde{F}(Y,X)\cdot\tilde{I}(Y,Z)$$

By the way, the necessary and sufficient condition for an arbitrary function $\alpha(Y,X)$ of $X\in B^n$, $Y\in B^m$ to be a generating function of a mapping : $B^n \to B^m$ is a proposition that a column vector of $\alpha(Y,X)$ for each X satisfies $\alpha(Y,X)$ =1 for only one *Y*.

The proposition that one function *g(Y)* satisfies $g(Y)$=1 for only one *Y* is equivalent to the following:

$$(28)\quad \bigcup_{Y}\overline{\tilde{I}(Z,Y)}\cdot g(Y)=\overline{g(Z)}\qquad (Y,Z\in B^m)$$

Firstly, this is proved as follows:

a) upon $g(Y)$=0,

$$\bigcup_{Y}\overline{\tilde{I}(Z,Y)}\cdot g(Y)=0\neq\overline{g(Z)}=1$$

b) When *g(Y)* is 1 at one position *P* among $2^m$ *Y*'s and 0 at all other positions, $\overline{I(Z,P)}$ is 0 upon *Z*=*P* and 1 otherwise. Thus the expression (28) is satisfied.

c) When *g(Y)* is 1 at two positions among $2^m$ *Y*'s, the following is satisfied:

$$\bigcup_{Y}\overline{\tilde{I}(Z,Y)}\cdot g(Y)=1\neq\overline{g(Z)}$$

The items a) ,b) and c) cover all cases. Thus the expression is proved. Such a function *g(Y)* is called a miniterm function because it composed of one miniterm.

Accordingly, the necessary and sufficient condition for the aforementioned $\alpha(Y,X)$ to be a generating function of a mapping is as follows:

$$(29)\quad \bigcup_{Y} \overline{\tilde{I}(Z,Y)} \cdot \tilde{F}(Y,X) = \overline{\tilde{F}(Z,X)} \text{ (for } \forall Y,Z \in B^m,\quad \forall X \in B^n)$$

According to the aspect, a mapping having multiple inputs/outputs is not treated with each component function. It can be treated in a lump by using a generating function. And the relation among various logic functions can be calculated efficiently and comprehensively.

[Third aspect of the invention]

The third aspect of the invention responds to the invention of Claim 7. Also, the third aspect combined with the second aspect responds to the invention of Claim 8.

Firstly, the satisfaction of the following expression:

$$(30)\ f(X)\cdot \overline{f(Y)}\cdot \Delta(X,Y)=0$$

for a logic function $f(X)$ is checked for various $\Delta(X,Y)$ to determine the complexity of the logic function $f(X)$. Using the generating function of mapping for each component function $f_j(X)$ ( $j = 1,2,\cdots,m$) of a mapping $F : B^n \to B^m$, the following expression:

$$(31)\quad \tilde{F}(X,A)\cdot \tilde{F}(Y,B)\cdot x_j \cdot \overline{y_j}\cdot \Delta_j(A,B)=0$$

is checked for $\Delta_j(A,B)$ to determine the complexity of logic functions $f_j(X)$ together.

As described in the section of [notation], the necessary and sufficient condition for a function $f(X)$ ( $X \in B^n$ ) to be independent of variables $x_i$ is $\frac{df(X)}{dx_i}$ =0 This condition can be expressed using the generating function $\tilde{I}(X,Y)$ of an identity transformation by the following expression:

$$(32)\quad f(X)\cdot \overline{f(Y)}\cdot \tilde{I}(X,Y^i)=0$$

where $X^i$ a vector derived by replacing *i* component $x_i$ of a vector $X$ with $\bar{x}_i$.

This is as follows:

by summing the expressions of the left hand member=0 of (32), $f(X)\cdot\overline{f(X^i)}$=0 is obtained from (19); by substitute inserting $X$ of this expression with $X'$, $f(X^i)\cdot\overline{f(X)}$=0 is obtained; and this is equivalent to the Boolean derivation $\frac{df(X)}{dx_i}$=0. The expression (32) corresponds to the expression (30) with letting $\Delta(X,Y)$ to

$$\Delta(X,Y)=\tilde{I}(X,Y^i)\ .$$

Further when $f(X)$ is independent of the variables $x_i$ and $x_j$, the necessary and sufficient condition is as follows:

$$f(X)\cdot\overline{f(Y)}\cdot\tilde{I}(X,Y^i)=0,\quad f(X)\cdot\overline{f(Y)}\cdot\tilde{I}(X,Y^j)=0,\quad f(X)\cdot\overline{f(Y)}\cdot\tilde{I}(X,Y^{ij})=0$$

where $X^{ij}$ is a vector derived by replacing $x_i,x_j$ of $X$ with $\bar{x}_i,\bar{x}_j$.

Further, let generally write a subset of *n*-variable set by $\Theta$; let write a subset of $\Theta$ by $L(L \subset \Theta)$; and let $X^L$ be a vector by replacing such variables of a vector $X$ as included in the set $L$ with their negations. Then the necessary and sufficient condition for the independency of the variable of a set Θ is:

$$(33) \quad f(X)\cdot\overline{f(Y)}\cdot\tilde{I}(X,Y^L)=0 \quad (for \ \ \forall L\subset\Theta)$$

Here, let write Θ, using $n$ Boolean values $\theta^l$, by $\Theta=\{l\ ;\ \theta^l=0\}$. Then the expression (33) can be expressed by:

$$(34) \quad f(X)\cdot\overline{f(Y)}\cdot\bigcap_l(x_l\cdot y_l\cup\overline{x_l}\cdot\overline{y_l}\cup\overline{\theta^l})=0$$

This is derived because:

$$\bigcup_{L\subset\Theta}\tilde{I}(X,Y^L)=\bigcap_l(x_l\cdot y_l\cup\overline{x_l}\cdot\overline{y_l}\cup\overline{\theta^l})$$

This $\theta^l$ is called a variable dependency of a function $f(X)$.

When the expression (34) is satisfied, $f(X)$ is not dependent on such a variable as $\theta^l$=0. The number of variables o which it depends is equal to or less than such a variable as $\theta^l$ =1. The expression (34) corresponds to the expression (30) with $\Delta(X,Y)$ satisfying

$$\Delta(X,Y)=\bigcap_l(x_l\cdot y_l\cup\overline{x_l}\cdot\overline{y_l}\cup\overline{\theta^l})\ .$$

Further, let write the variable dependency of each component function $f_j(X)$ ( $j$ = 1,2,···,$m$) of a mapping $F$ : $B^n\rightarrow B^m$ by $\theta^l_j$. Then all mappings are expressed in a lump using the generating function corresponding to the expression (34) by:

$$(35) \quad \tilde{F}(X,A)\cdot\tilde{F}(Y,B)\cdot x_j\cdot\overline{y_j}\cdot\bigcap_l(a_l\cdot b_l\cup\overline{a_l}\cdot\overline{b_l}\cup\theta_j{}^l)=0$$

This expression (35) corresponds to the expression (31) with $\Delta_j(A,B)$ satisfying

$$\Delta_j(A,B)=\bigcap_l(a_l\cdot b_l\cup\overline{a_l}\cdot\overline{b_l}\cup\theta_j{}^l)\ .$$

These $\Delta(X,Y)$ and $\Delta_j(A,B)$ are hereinafter referred to as variable dependency functions.

According to the third aspect of the invention, the variable dependency of a logic function for plural variables can be checked in a lump by determining whether or not an equation is satisfied. This third aspect in combination with the second aspect enables to design logic functions.

[Fourth aspect of the invention]

The fourth aspect of the invention corresponds to the invention of Claim 9.

Let restrict r=2. Then the operations (mappings) of the old operation system are $G^q{}_O$: $B^n\rightarrow B^n$, $F^p{}_O$: $B^n\times B^n\rightarrow B^n$ , $H^s{}_O$: $B^n\times B^n\times\cdots\times B^n\rightarrow B^n$; the encoder (mapping) of the new operation system is $\Phi : B^n\rightarrow B^m$ ; the decoder

(mapping) is $\Psi : B^m \rightarrow B^n$; the operators (mappings) of the new operation system are $G^q{}_N: B^m \rightarrow B^m$, $F^p{}_N: B^m \times B^m \rightarrow B^m$ , $H^s{}_N: B^m \times B^m \times \cdots \times B^m \rightarrow B^m$. The component functions of the operations of the old operation system, and the operations, the encoder and the decoder are expressed:

$$G^qO{:}g_i^qO(X),\ F^pO{:}f_i^pO(X,Y),\ H^sO{:}h_i^sO(X_1,X_2,\cdots,X_T)$$

and

$$G^qN{:}g_j^qN(X'),\ F^pN{:}f_j^pN(X',Y'),\ H^sN{:}h_j^sN(X'_1,X'_2,\cdots,X'_T),\ \Phi{:}\phi_j(X),\ \Phi{:}\phi_j(X),$$

$$\Psi{:}\psi_i(X')$$

where $i=1,2,\cdots,n$, $X,Y,Z,X_1,X_2,\cdots,X_T \in B^n$, $j=1,2,\cdots,m$, $X',Y',Z',X'_1,X'_2,\cdots,X'_T \in B^m$

Let use, for these mappings, a generating function described with the second aspect of the invention; and let write the characteristic logic function $\chi_C(X')$ of the code range $C$ by $c(X')$. Then, forr=2, the following expressions (1-b) to (5-b-2) equivalent to the expressions (1-c) to (5-c) are obtained. These expressions (1-b) to (5-b-2) are suffixed with "b" to indicate explicitly that they are Boolean function expressions.

(1-b) $$\tilde{\Psi}(X,X')\cdot c(X')\cdot\tilde{\Phi}(X',X)=\tilde{\Phi}(X',X)$$

(2-b) $$\bigcup_{X'}\tilde{\Phi}(X',X)\cdot\tilde{\Phi}(X',Y)=\tilde{I}(X,Y)$$

(3-b-1) $$\overline{\tilde{G}^q o(Y,X)}\cdot\tilde{G}^q{}_N(Y',X')\cdot\tilde{\Psi}(Y,Y')c(Y')\cdot\tilde{\Psi}(X,X')c(X')=0$$

(3-b-2) $$\overline{c(Y')}\cdot c(X')\cdot\tilde{G}^q{}_N(Y',X')=0$$

(4-b-1)

$$\overline{\tilde{F}^p o(Z,Y,X)}\cdot\tilde{F}^p{}_N(Z',Y',X')\cdot\tilde{\Psi}(Z,Z')c(Z')\cdot\tilde{\Psi}(Y,Y')c(Y')\cdot\tilde{\Psi}(X,X')c(X')=0$$

(4-b-2) (4-b-2) $$\overline{c(Z')}\cdot c(Y')\cdot c(X')\cdot\tilde{F}^p{}_N(Z',Y',X')=0$$

(5-b-1)

$$\overline{\tilde{H}^s o(Y,X_1,\cdots,X_T)}\cdot\tilde{H}^s{}_N(Y',X'_1,\cdots,X'_T)\cdot\tilde{\Psi}(Y,Y')c(Y')\cdot\tilde{\Psi}(X_1,X'_1)c(X'_1)\cdots\tilde{\Psi}(X_T,X'_T)c(X'_T)=0$$

(5-b-2) $$\overline{c(Y')}\cdot c(X'_1)\cdot\cdots\cdot c(X')\cdot\tilde{H}^s{}_N(Y',X'_1,\cdots,X'_T)=0$$

$$\tilde{\Phi}(X',X)$$

is the generating function of the encoder;

$$\widetilde{\Psi}(X, X')$$

is the generating function of the decoder;

$$\widetilde{G}^{q}o(Y, X)$$

are the generating functions of the unary operations of the old operation system;

$$\widetilde{F}^{p}o(Z, Y, X)$$

are the generating functions of the binary operations of the old operation system;

$$\widetilde{G}^{q}{}_{N}(Y', X')$$

are the generating functions of the unary operations of the new operations system;

$$\widetilde{F}^{p}{}_{N}(Z', Y', X')$$

are the generating functions of the binary operations of the new operation system;

$$\widetilde{H}^{s}o(Y, X_1, \cdots, X_T)$$

are the generating functions of T-nary operations of the old operation system; and

$$\widetilde{H}^{s}{}_{N}(Y', X'_1, \cdots, X'_T)$$

are the generating functions of the T-nary operations of the new operation system.

The expressions (1-b) to (5-b-2) are derived by the equivalent transformation of the expressions (1-c) to ((5-c) below.

Firstly, the characteristic function $\chi'_{[X]}(X')$ of the set [$X$] indicating a code $X$ is clearly expressed, using the characteristic function of the decoder Ψ by the following:

$$(36) \qquad \chi'_{[X]}(X') = \widetilde{\Psi}(X, X') \cdot c(X')$$

Let suppose that this expression (36) is a function of $X'$. From the property (18) of a generating function, the expression (1c) is equivalent to the following:

$$(37) \qquad \bigcup_{X'} \widetilde{\Psi}(X, X') \cdot c(X') \cdot \widetilde{\Phi}(X', X) = 1$$

Also, form the property (27) of the generating function, the following is satisfied:

$$(38)\quad \tilde{\Phi}(X',X)\cdot\tilde{\Phi}(Y',X)=\tilde{\Phi}(X',X)\cdot\tilde{I}(X',Y')$$

Then, by multiplying both side members of (37) with

$$\tilde{\Phi}(Y',X)\ ,$$

and summing those using the property (19) of the generating function, and modifying the variable $Y'$ into $X'$, the expression (1-b) is obtained.

Next, from the properties (10), (16), (2-c) of the characteristic logic function and generating function, the following is obtained:

$$(39)\quad \chi_{\Psi([Y])}(X)=\bigcup_{X'}\tilde{\Psi}(X,X')\cdot\varphi'_{[Y]}(X')=\bigcup_{X'}\tilde{\Psi}(X,X')\cdot\tilde{\Psi}(Y,X')\cdot c(X')$$

Reviewing (2), (2c) is equivalent to the following:

$$(40)\ \chi_{\Psi([Y])}(X)=\chi_Y(X)$$

(2c) is, from (39), (40) and the property (27) of the generating function, equivalent to the following:

$$(41)\ \bigcup_{X'}\tilde{\Psi}(X,X')\cdot\tilde{I}(X,Y)\cdot c(X')=\tilde{I}(X,Y)$$

By summing the both side members of this expression for $Y$, (2-b) is obtained from the property (22) of the generating function.

Next, from the property (14) of the generating function, (3c) is clearly equivalent to the following:

$$(42)\ \chi'_{Gq_{N([X])}}(Y')\cdot\overline{\chi'_{[Gq_{O(X)}]}(Y')}=0$$

Also, from (36), the following is obtained:

$$(43)\quad \chi'_{[G^q{}_O(X)]}(Y')=\tilde{\Psi}(G^q{}_O(X),Y')\cdot c(Y')$$

Also, from (36) and the properties (10) and (16) of the characteristic function and the generating function, the following is obtained:

$$(44)\quad \chi'_{G^q{}_N([X])}(Y')=\bigcup_{X'}\tilde{G}^q{}_N(Y',X')\cdot\chi'_{[X]}(X')=\bigcup_{X'}\tilde{G}^q{}_N(Y',X')\cdot\tilde{\Psi}(X,X')c(X')$$

By substituting (43) and (44) to (42) and removing the sumbecause of Boolean expressions of a "=0" type, the following is obtained:

$$(45)\quad \widetilde{G}^{q}{}_{N}(Y',X')\cdot\widetilde{\Psi}(X,X')\cdot c(X')\cdot\overline{\widetilde{\Psi}(G^{q}{}_{O}(X),Y')\cdot c(Y')}=0$$

This is divided into the following expressions by dividing the negation portion:

$$(46)\quad \widetilde{G}^{q}{}_{N}(Y',X')\cdot\widetilde{\Psi}(X,X')\cdot c(X')\cdot\overline{\widetilde{\Psi}(G^{q}{}_{O}(X),Y')}=0$$

$$(47)\quad \widetilde{G}^{q}{}_{N}(Y',X')\cdot\widetilde{\Psi}(X,X')\cdot c(X')\cdot\overline{c(Y')}=0$$

By applying the properties (18) and (29) to the expression (46), the expression(3-b-1) is obtained; and by summing (47) for *X* and applying the property (22) of the generating function, the expression (3-b-2) is obtained. Likewise, (4-b-1) and (4-b-2) obtained from (4-c); and (5-b-1) and (5-b-2) obtained from (5-c).

As described above, (1-b) to (5-b-2) are obtained and the encoding conditions of the old operation system and the new operations system are expressed by clear Boolean logic equations. This enables to efficiently determine a new operation system from the information of component functions of an old operation system by binary search.

[Fifth aspect of the invention]

The fifth aspect of the invention corresponds to the inventions of Claim 10 to 12.

In this aspect, in addition to the above mentioned expressions (1-b) to (5-b-2), the conditions for simplifying the logics of operators of the new operation system are imposed. The encoder, decoder and operators are logic-designed under those conditions, and the circuit scale and operation delay time are reduced. Further, the imposed condition to unary operations is:

$$(48)\quad \widetilde{G}^{q}{}_{N}(X',A')\cdot\widetilde{G}^{q}{}_{N}(Y',B')\cdot x'_j\cdot\overline{y'_j}\cdot\bigcap_{l}(a'_l\cdot b'_l\cup\overline{a'_l}\cdot\overline{b'_l}\cup\overline{\lambda^{q}{}_{j}{}^{l}})=0$$

The imposed conditions to binary operations are:

$$(49)\quad \widetilde{F}^{p}{}_{N}(X',A',C')\cdot\widetilde{F}^{p}{}_{N}(Y',B',C')\cdot x'_j\cdot\overline{y'_j}\cdot\bigcap_{l}(a'_l\cdot b'_l\cup\overline{a'_l}\cdot\overline{b'_l}\cup\overline{\theta_1{}^{p}{}_{j}{}^{l}})=0$$

$$\widetilde{F}^{p}{}_{N}(X',C',A')\cdot\widetilde{F}^{p}{}_{N}(Y',C',B')\cdot x'_j\cdot\overline{y'_j}\cdot\bigcap_{l}(a'_l\cdot b'_l\cup\overline{a'_l}\cdot\overline{b'_l}\cup\overline{\theta_2{}^{p}{}_{j}{}^{l}})=0$$

The imposed conditions to T-nary operations are: (50)

$$\widetilde{H}^{p}{}_{N}(X',A',C'_2,\cdots,C'_T)\cdot\widetilde{H}^{p}{}_{N}(Y',B',C'_2,\cdots,C'_T)\cdot x'_j\cdot\overline{y'_j}\cdot\bigcap_{l}(a'_l\cdot b'_l\cup\overline{a'_l}\cdot\overline{b'_l}\cup\overline{\mu_1{}^{p}{}_{j}{}^{l}})=0$$

Values of $\lambda q^{l}_{j}$ and $\theta^{pl}_{1j}$,$\theta^{pl}_{2j}$ and $\mu^{sl}_{lj}$ to $\mu^{sl}_{Tj}$ are determined such that the variable dependency of the new operators for input variables is less than one of the old operation system. The circuit scale and operation delay time of such designed encoder, decoder and operators are reduced.

If required, the condition of $\theta^{pl}_{1j}=\theta^{pl}_{2j}$ for the above mentioned $\theta^{pl}_{1j}$ and $\theta^{pl}_{2j}$ as the simplification condition is imposed to symmetrically logic-design the binary operations of the new operation system. Further, the condition of $\mu^{sl}_{1j}=\cdots=\mu^{sl}_{Tj}$ for the above mentioned $\mu^{sl}_{lj}$ to $\mu^{sl}_{Tj}$ is imposed to symmetrically design T-nary operations of the new operation system.

[Sixth aspect of the invention]

The sixth aspect of the invention corresponds to the inventions of Claims 13 and 14.

Let suppose that, when the space $B^n_r$ of the old representation data and the space $B^m_r$ of the new representation data is the same as are same ($B^n_r=B^m_r$, $n=m$), the encoder Φ is an isomorphic mapping $\Phi:B^n_r\rightarrow B^n_r$, and the decoder Ψ is $\Psi=\Phi^{-1}$ ( an inverse mapping of Φ). Then, if the encoder is an isomorphic mapping, the expressions (1) and (2) are clearly satisfied.

It is sufficient instead of (1-b) and (2-b) that the following condition for

$$\tilde{\Phi}(Y,X)$$

to be the generating function of an isomorphic mapping is satisfied:

$$(51)\quad \begin{array}{l} \bigcup_{Y}\overline{\tilde{I}(Z,Y)}\cdot\tilde{\Phi}(Y,X)=\overline{\tilde{\Phi}(Z,X)} \\ \bigcup_{Y}\overline{\tilde{I}(Z,Y)}\cdot\tilde{\Phi}(X,Y)=\overline{\tilde{\Phi}(X,Z)} \end{array} \quad (\text{for } \forall X,Y,Z\in B^n)$$

Also, (51) is derived by exchanging the inputs and outputs of (29). The relation expression of the new and old operation systems corresponding to (3-b-1) and (3-b-2) of a unary operation is replaced with the condition that the following expression is satisfied:

$$(52)\quad \tilde{G}^q{}_N(Y',X')=\bigcup_{Y}\bigcup_{X}\tilde{G}^q{}_O(Y,X)\cdot\tilde{\Phi}(Y',Y)\cdot\tilde{\Phi}(X',X)$$

Likewise, the following expressions are satisfied:

$$(53)\quad \tilde{F}^p{}_N(Z',X',Y')=\bigcup_{Z}\bigcup_{X}\bigcup_{Y}\tilde{F}^p{}_O(Z,X,Y)\cdot\tilde{\Phi}(Z',Z)\cdot\tilde{\Phi}(X',X)\cdot\tilde{\Phi}(Y',Y)$$

$$(54)\quad \tilde{H}^s{}_N(Y',X'_1,\cdots,X'_T)=\bigcup_{Y}\bigcup_{X_1}\cdots\bigcup_{X_T}\tilde{H}^s{}_O(Y,X_1,\cdots,X_T)\cdot\tilde{\Phi}(Y',Y)\cdot\tilde{\Phi}(X'_1,X_1)\cdots\tilde{\Phi}(X'_T,X_T)$$

Here, when the variable dependency (48) is required for the new operation system, (48) is applied to (52). By summing for *X',Y',A',B'*, the following is obtained:

(55)

$$\tilde{G}^q o(X,A)\cdot\tilde{G}^q o(Y,B)\cdot\phi_j(X)\cdot\overline{\phi_j(Y)}\cdot\bigcap_l(\phi_l(A)\cdot\phi_l(B)\cup\overline{\phi_l(A)}\cdot\overline{\phi_l(B)}\cup\overline{\lambda^q{}_j{}^l})=0$$

Likewise, when the variable dependencies (49) and (50) are required, the following expressions are obtained:

(56)

$$\tilde{F}^p o(X,A,C)\cdot\tilde{F}^p o(Y,B,C)\cdot\phi_j(X)\cdot\overline{\phi_j(Y)}\cdot\bigcap_l(\phi_l(A)\cdot\phi_l(B)\cup\overline{\phi_l(A)}\cdot\overline{\phi_l(B)}\cup\overline{\theta_1{}^p{}_j{}^l})=0$$

$$\tilde{F}^p o(X,C,A)\cdot\tilde{F}^p o(Y,C,B)\cdot\phi_j(X)\cdot\overline{\phi_j(Y)}\cdot\bigcap_l(\phi_l(A)\cdot\phi_l(B)\cup\overline{\phi_l(A)}\cdot\overline{\phi_l(B)}\cup\overline{\theta_2{}^p{}_j{}^l})=0$$

(57)

$$\tilde{H}^s o(X,A,C_2,\cdots,C_T)\cdot\tilde{H}^s o(Y,B,C_2,\cdots,C_T)\cdot\phi_j(X)\cdot\overline{\phi_j(Y)}\cdot\bigcap_l(\phi_l(A)\cdot\phi_l(B)\cup\overline{\phi_l(A)\cdot\phi_l(B)}\cup\overline{\mu_1{}^s{}_j{}^l})=0$$

$$\tilde{H}^s o(X,C_1,A,\cdots,C_T)\cdot\tilde{H}^s o(Y,C_1,B,\cdots,C_T)\cdot\phi_j(X)\cdot\overline{\phi_j(Y)}\cdot\bigcap_l(\phi_l(A)\cdot\phi_l(B)\cup\overline{\phi_l(A)\cdot\phi_l(B)}\cup\overline{\mu_2{}^s{}_j{}^l})=0$$

. . . . . . . . . . . . . . . . . . . . .

$$\tilde{H}^s o(X,C_1,C_2,\cdots,A)\cdot\tilde{H}^s o(Y,C_1,C_2,\cdots,B)\cdot\phi_j(X)\cdot\overline{\phi_j(Y)}\cdot\bigcap_l(\phi_l(A)\cdot\phi_l(B)\cup\overline{\phi_l(A)\cdot\phi_l(B)}\cup\overline{\mu_T{}^s{}_j{}^l})=0$$

Considering that (55), (56) and (57) are the equations composed of only the generating function of operations of the old operation system and encoding component functions, the following determination procedure can be taken:
<Step 1> Determine an encoder ( its component functions) satisfied (51) and (55) to (57) for given variable dependency.
<Step 2> Determine the operators of the new operation system from (52) to (54).
<Stet 3> Determine the decoder $\Psi$ from $\Psi=\Phi^{-1}$, which is interpreted to

$$\tilde{\Psi}(Y,X)=\tilde{\Phi}(X,Y)$$

for the generating function. ( The steps 2 and 3 can be performed in the reverse order.)

Because that determination procedure does not include the information of operators of a new operation system, less factors need to be determined, and a code can be determined efficiently.

According to the invention, the encoding operation device can be provide for which the operation result can be calculated based on the flow of the encoding operation method. In particular, the above mentioned method of logic designing is performed to enable to logic design concretely the encoding operation method including redundant codes; the logic equations obtained from the logic design based on the encoding operation method enables to concretely design circuitry, and operation result can be calculated based on the flow of the encoding operations method.

Also, an encoding operation device having one or more types of new operators can be provided in which the new operators are directly connected to eliminate the time of delay through a memory for plural operations for the new representation data and to achieve fast processing.

Further, an encoding operation device can be provided in which, under the control of a CPU or a data control unit, the operation result obtained as the new representation data by one or more new operators is not directly converted to the old representation data by the decoder but stored in the memory still as the new representation data, and is processed using the new operators, with another new representation data calculated through another calculation process to enable flexible modification of a calculation process and the like according to a program. According to the invention, the above mentioned means resolves the problem vi) of the related document.

It should be noted that the present invention can be realized as not only a device or a system but also a method. At least a part of such a realized invention implemented in software. Also, a software product used for performing such software in a computer is within the scope of the invention.

According the invention, the problems of the related document can be resolved, the new operation system of an encoding operation method can be logic-designed concretely and efficiently, and an encoding operation device can be provided in which the circuit element number and the time delay are reduced to achieve fast operation and low power consumption.

Brief Description of the Drawings

Fig.1 is a conceptual drawing of the encoding of the invention.

Fig.2 is a conceptual drawing of the extension from the original operation system to the old operation system according to the invention.

F.g.3 is a drawing of an example of the old operation system and new operation system determination flow of the invention.

Fig. 4 is a drawing of the configuration of the operation device configured with the invention.

Fig.5 is a drawing of details of the old operation system and new operation system determination flow of the invention.

Fig.6 is a drawing of details of the old operation system and new operation system determination flow of another example of the invention.

Fig.7 is a drawing illustrating the truth table of a pseudo multiplier $F^1$ of the original operation system in connection with the example 1 of the invention.

Fig.8 is a drawing illustrating the truth table of a pseudo adder $F^2$ of the original operation system in connection with the example 1 of the invention.

Fig.9 is a drawing illustrating the circuit diagram of the pseudo multiplier $F^1$ of the original operation system in connection with the example 1 of the invention.

Fig.10 is a drawing illustrating the circuit diagram of the pseudo adder $F^2$ of the original operation system in connection with the example 1 of the invention.

Fig.11 is a drawing illustrating the determination flow of the new operation system in connection with the example 1 of the invention.

Fig.12 is a drawing illustrating the truth table of a pseudo multiplier $F^2{}_N$ of the new operation system in connection with the example 1 of the invention.

Fig.13 is a drawing illustrating the truth table of a pseudo adder $F^1{}_N$ of the new operation system in connection with the example 1 of the invention.

Fig. 14 is a drawing illustrating the truth table of an encoder Φ of the new operation system in connection with the example 1 of the invention.

Fig. 15 is a drawing illustrating the truth table of a decoder Ψ of the new operation system in connection with the example 1 of the invention.

Fig.16 is a drawing illustrating the circuit diagram of the pseudo multiplier $F^1{}_N$ of the new operation system in connection with the example 1 of the invention.

Fig.17 is a drawing illustrating the circuit diagram of the pseudo adder $F^2{}_N$ of the new operation system in connection with the example 1 of the invention.

Fig.18 is a drawing illustrating the circuit diagram of the encoder multiplier Φ of the new operation system in connection with the example 1 of the invention.

Fig.19 is a drawing illustrating the circuit diagram of the decoder Ψ of the new operation system in connection with the example 1 of the invention.

Fig.20 is a drawing illustrating a table of circuit element numbers and delay times in connection with the example 1 of the invention.

Fig.21 is a drawing illustrating the block diagram of a product sum operator in connection with the example 1 of the invention.

Fig.22 is a drawing illustrating a pseudo product sum operator in connection with the example 1 of the invention.

Fig.23 is a drawing illustrating the truth tables of two unary operations $G^1$, $G^2$ of the original operation system in connection with the example 2 of the invention.

Fig.24 is a drawing illustrating the generating function Boolean matrices of two unary operations $G^1$, $G^2$ of the original operation system in connection with the example 2 of the invention.

Fig.25 is a drawing illustrating the new operation system determination flow in connection with an example of the invention.

Fig. 26 is a drawing illustrating the input/output topologies of unary operations $G^1$, $G^2$ of the original operation system in connection with the example 2 of the invention.

Fig.27isadrawingillustratingtheinput/outputtopologies of unary operations $G^1{}_N$ , $G^2{}_N$ of the new operation system in connection with the example 2 of the invention.

Fig.28 is a drawing illustrating the input/output topologies of tied unary operations $G^1{}_N$,$G^2{}_N$ of the new operation system in connection with the example 2 of the invention.

Fig.29 is a drawing illustrating the determination flow of topology matched new operation system in connection with the example 2 of the invention.

## Best Modes for Carryinq Out the Invention

The embodiments of the invention are described below.

The methods of the inventions of Claim 3 to 8 are described. What is described can be appropriately applied to the devices of the inventions of Claim 1 and 2 and the methods of inventions of Claim 9 to 14.

[First Embodiment]

The invention of Claim 3 is described.

First of all, the embodiment is illustrated in which the flow of Fig.3 with the encoding conditions of Clam 3 and 4 is performed for the old operation system with r=2 and n=2 with one unary operation Go given component functions $g_{O0}(A)=a_1$,$g_{O1}$(A)=$a_1 \cdot a_0$, and new operations with m=3. Fig.5 is a flow chart illustrating the general flow of the program of the embodiment of the invention of Claim 3 ( the embodiment of the invention of Claim 4 is same). The variables and arrays used for the program are as follows:

x: old code and non code variable; variables corresponding to values 0 to 3 of *X*, and non code (its value is 4)
y: new code variable; variables corresponding to 0 to 7 of *X'*.
r: random number variable; variables indicating 0 to 255 of produced 8 bit random numbers
i,j,k: modified variables produced by new operators
l,t,u,v: general variables
c[4] : produced code array; four arrays corresponding to four types of codes [*X*], where each bit corresponding to the vale of the new code which the produced code belong to is "1", and each bit which does not belong is "0". The values of the new code are aligned to bits from the LSB side.
go[4]: array of mappings of old operators; go[0]=0, go[1]=0, go[2]=1, go[3]=3
gn[8]: array of mappings of new operators; arrays having array addresses related to input values of mappings of new operators produced in each step and having those output as corresponding values.
gne[3]: new operator component functions; array indicating three component functions of a new operator where each bit of each component logic equation is "1" at which it includes theminiterm $X^0,\cdots,X^7$ from the LSB side.
gnc[4]: new operator code substitution function
s[6]: 3 bit formal component function array; an array indicating 3 type of 3 bit one variable logic functions (non negation type) and their negation type one variable logic functions in the same manner as gne [3]. In particular, let the bit patterns of one variable logic functions (non negation type) are the following three types:01010101, 00110011, 00001111. Then s[0]=170,s[1]=204,s[2]=240. Those negations are substituted the following array positions; s[3]=85,s[4]=41,s[5]=15
b0[8]: one bit 0 pattern array; b[t] has "0" at t-th bit position and "1" at the others positions
b1[8]: one bit 1 pattern array; b[t] has "1" at t-th bit position and "0" at the others positions

The detailed process of the flow of Fig.5 applied to Claim 3 is described below.

[Step S11]: Initialize.

Other arrays and variables than go [4] , s[3], sn[3] are set "0".

[Step S12]: Generated code.

Generate a random number r. Considering that the new code y belongs to the code [*X*] (or NC) corresponding to mod (r,5), set "1" at y-th position of c[mod(r,5)].
[Step S13, S14]: y=y+1. If y=8 then go to the step 2, otherwise go to the step S15.
[Step S15]: Check the encoding conditions (1) and (2). The satisfaction of the condition (1) is equivalent to that at least one of the four [*X*] is set with a new code. This means that not all of c[0]~c[3] are "0". If at least one "0" exist, then returns to the step 1. If there is no "0", then proceeds to the step 16. For example, if codes such as [0]={6 }, [1]={2 }, [2]={0 ,4 }, [3]={1 ,3 ,5 ,7 }, NC=empty set are generated, the value are c[0]=64,c[1]=4,c[2]=17,c[3]=85, and then the step 5 is taken.
[Step S16]: new operators are generated. When the encoding condition (1) is satisfied then an encoder $\Phi$ and a decoder $\Psi$ are ensured. Thus new operators are generated. In this embodiment, because the old operator is one and gate, the simplification is limited to producing a one variable dependency logic function. Accordingly, the component function of new operators any of the six type of component functions including non negation type formal component functions and negation type formal component functions. Thus, the new operators are generated such as gne[0]=s[i], gne[1]=s[j], gne[2]=s[k].
[Step S17]: The encoding condition (3) is checked.
Firstly, gn[8] is calculated from gne[3] ad follows.
The values of t-th bit from the bottom of gne[0], gn[1], gn[2] are moved to 0-th bit (LSB), 1-st bit and 2-nd bit of gn[t] and 3-th and upper bit remains "0". This process is performed from t=0 to t=7 to determine gn[8].
Next, for values t at every bit position where c[u] is set "1" (LSB is "0" and the value is incremented by 1 for one upper position) , a value gn[t]-th bit value of v is set "1".
When the bit pattern of c[go[u]] includes the bit pattern of v, then u=u+1, and the process is repeated until u=3. When it becomes not including the bit pattern on the way, it means that the encoding condition (3) is not satisfied. Thus the control goes to the step S18. When the process has been repeated through to the completion, it means the encoding condition (3) is satisfied. Thus the control goes to the step S208.
[Step S18 and S19]: values of i, j, k are modified. [ｽﾃｯﾌﾟ S18, S19]: After the modification the control goes to the step 5. However, when i, j, k have taken all the value of 0 to 5, it means that no new operator having one variable dependency exists. Thus the variables and the like are initialized and then the control goes to the step S12.
[Step S20] : According to the encoding condition (1) new codes among [0] to [3] are selected from portions at which the bit pattern of the array c[4] is "1". For example, the correspondence such as 0->1 ,1->0 ,2->4 ,3->2 is determined. Generally, plural encoders can exist. One making logic equations simpler may be selected. Because it is ensured that decoders satisfying the encoding condition (2) exist, the description of this embodiment is brought to completion.

Variables and the like are initialized at appropriate timings.

With that the description of the process of Fig.5 is completed.

In that embodiment, the code exemplified in the step 4 are produced by random numbers, and the process finishes with i=0, J=3, k=1.

Thatmeanswhenthecodeis [0]={6 }, [1]={2 }, [2]={0 ,4 }, [3]={1 ,3 ,5 ,7 }, NC=empty set, the new operator whose logic equation is $g_{N0}(A')=a'_1, g_{N1}(A')=a'_2, g_{N2}(A')=a'_0$ is obtained.

While in that embodiment the old operator is a single one for a unary operation, alternatives which include plural binary operations and T-nary operations can be realized basically by the same flow processed with a computer except that the encoding conditions (4) and (5) are checked in addition to the encoding condition (3) , and that the process of the step 5 for the generation of the new operators is complicated.

As described above, the operation design method of Claim 3 enables to obtain new operators less complicated than old operators.

[Second Embodiment]

Next, the embodiment of the operation device design method of Claim 4 is described. In this embodiment the encoding conditions (1) to (3) of the flow of Fig.5 are replaced with (1c) to (3c) for the determination. The distinctive portion of this process is different from the embodiment of the invention of Claim 3 only in connection with the step S17 for calculating the characteristic functions of the codes produced in the step 12 and checking the condition, and the step S20 for determining the codes.

Let suppose the same case as the described above, that is, the codes are generated such as [0]={6 }, [1]={2 }, [2]={0 ,4 }, [3]={1 ,3 ,5 ,7 }, NC=empty set, and the new operator is $g_{N0}(A')=a'_0, g_{N1}(A')=\overline{a'_0}, g_{N2}(A')=a'_1$.

As previously described, c[4] is obtained from the codes generated in the step 2. The fact is that this corresponds to a logic function $\chi'_{[X]}(X')$ of each $X$ , which is a characteristic logic function on $B^3$. That is, u of c[u] corresponds to X, and the bit pattern of c[u] for each u is a logic function on $B^3$ in the same sense of gne[3].

Thus, the encoding condition (3) of the step 6 is modified to (3c) as follows.
(The step S17 of the embodiment of the invention of Claim 4)

In the same way as Claim 3, gn[8] is calculated from gne [3] , and v is calculated likewise. The logic sum of c[go[u]] and the bit pattern of v is calculated, and the calculation result is checked for 255. This corresponds to determination that the characteristic function of the left side of the equation (3c) is "1".

Then u=u+1, and the process is repeated until u=3. When it is not 255 on the way, it means that the encoding condition (3c) is not satisfied. Then, the control proceeds to the step S18.

When the control successes with the final one, it means the encoding condition (3c) is satisfied. Then the control proceeds to the step S20.

(The step S20 of the embodiment of the invention of Claim 4)

The logic sum of c[u] and b0[t] for o to 3 of u is checked for 255, and the encoder is determined. This corresponds to the determination of the encoder by encoding condition (3c).

As far as the decoder is concerned, it is same as in the step S20 of Claim 3.

Those are different points of the embodiment of the invention of Claim 4. The two steps are modified by replacing from the procedural processes to simplified logic operations and equal check operations to achieve simple program process.

As mentioned above, the operation device design method of the invention of Claim 4 can realize efficient program process and reduce the time required for the design.

[The third embodiment]

Next, two embodiments of the invention of Claim 5 are described.

The first one is an embodiment in which portions conducting the logic sum operation in the two steps are replaced with the equation (14) of Claim 5 (its negation).

In the second one, the equation (8) of Claim 5 is applied to the code generation in the step 2. Suppose that the new code ybelong to [*X*] (or NC) corresponding to mod (r,5). Then, c [mod (r,5)] is replaced with the logic sum of c[mod(r,5)] and b1[y].

[Fourth embodiment]

Next, the embodiment of the invention of Claim 5 is described. The equations (9) to (13) of Claim 5 can be also used for operations among elements of a set. Accordingly, the logic function design method of Claim 5 can replace procedural processes with simplified logic operations to achieve efficient process.

[The fifth embodiment]

Next, the embodiment of the invention of Claim 6 is described

The important point of the logic function design method of Claim 6 is that plural logic functions having multiple inputs/multiple outputs can be clearly calculated by using a equation based on a generating function.

While the application of a generating function covers a lot of grounds, the following example is shown as a typical embodiment of the method using a generating function: a two inputs 3 outputs logic function A and a 3 inputs 2 outputs logic function are given; a 2 inputs 2 outputs logic function C is composed by substituting A to B; and the component logic functions of the logic function C are obtained by the program.

In this embodiment, the inputs of a logic function is related to the address of a array, the outputs are related to miniterms, and it is indicated by 0,1.

Because the program of the calculation based on the equation is easily implemented, only the flow of the process is illustrated below.

The arrays used for the program is as follows.

a[3][4]: 2 inputs 3 outputs logic function A; array of component function for each three outputs
b[2] [8] : 3 inputs 2 outputs logic function B; array of component function for each two outputs
c[2][4]: 2 inputs 2 outputs logic function C; array of component function for each two outputs
ma[8][4]: generating function array of A;
mb[4][8]: generating function array of B;
mc[4][4]: generating function array of C
a[3][4], b[2][8] are already inputted with values 0, 1.

The flow of the process is as follows:

(Step 1) The generating functions ma[8][4], mb[4][8] are calculated from the component logic functions a[3][4], b [2][8] according to the definition equation (16) for a generating function of Claim 6.

(Step 2) The generating function mc[4] [4] is calculated from the generating functions ma [8] [4], mb [4] [8] according to the equation (17) of Claim 6.

(Step 3) The component logic function c[2][4] is calculated from the generating function mc[4][4] according to the equation (20) of Claim 6.

As described above, the calculation can be conducted only a simple program composed of 3 steps.

In this manner, the logic function design method of the invention of Claim 6 can be implemented with program based on the clearly defined equations and enables to design them simply and efficiently.

[The six embodiment]

Next, the embodiment of the invention of Claim 7 is described below.

The important point of the logic function design method of the invention of Claim 7 is that variable dependency can be calculated efficiently based on clear equations.

Suppose a problem that a logic function should be selected among 100 given 4 inputs logic functions, which is independent of specified variables. Here, only the flow of the determination programthereof based on the equation (34) of Claim 7 is illustrated. The constants and variables are as follows. A logic function array is corresponds to mimiterm and "1" is inserted at the address and otherwise "0".

f[100][16]: 100 4 bit logic functions; given constants
fn[100][16]: negated logic functions of the above mentioned 100 logic functions:0, 1 are reversed against the above mentioned functions
e[4] : specified variable dependency; constant array inserted with the value such as e[u]= $\theta^u$.

delta[16][16]: variable dependency function; one corresponding to $\Delta(X,Y)$ of the equation (34)
d[100]: determination result array;
s[4][16]: 4 formal component logic function array; constant array corresponding to four logic functions of $x_0$~$x_3$.
sn[4][16]: 4 formal component negation logic function array: constant array corresponding to logic functions of $\overline{x_0}$~$\overline{x_3}$. i, j, k: general variables

(Step 1) The variable dependency function delta[16][16] is calculated from given e [4] based on the definition of $\Delta(X, Y)$ shown in Claim 7. Let k=0.
(Step 2) The left side of the equation (34) is calculated as follows.
f[k][i]*fn[k][j]*delta[i][j] is summed over every i, j. If the calculation result is "0", then d[k]=1, and other wise d[k]=0. Let k=k+1. If k=100, then go to the step 3, otherwise return to the step 2.
(Step 3) Select a logic function. A logic function such as d[k]=1 is selected.

This is the embodiment of the invention of Claim 7. The logic function design method of the invention of Claim 7 can calculate a preliminarily specified variable dependency function by clearly defined equations, and analyze them in one lump, and be then processed much more efficiently than the conventional methods which check independency for each variable in series or for each component.

[The seventh embodiment]

The important point of the invention of Claim 8 is that this method is used for various logic designs by calculation and determination of Claim 5 to Claim 7 in a comprehensive manner.

Fig.6 is a block diagram of the program of Claim 6, in which the program has seven processing steps illustrated as the following step 1 to step 7 and one step for controlling the flow among the steps indicated with the step 8.
[Step S21]: characteristic logic function transformation step. The inputted relation among sets is transformed to characteristic functions using relation expressions (8) to (14).
[Step S22]: characteristic logic function relation determination step.
It is checked whether or not The equations of the transformed characteristic logic functions are satisfied.
[Step S23]: mapping component function and generating function input step.
The component functions and/or the generating function of each mapping are inputted.
[Step S24]: generating function calculation step.
The generating function is calculated based on the equation (16).
[Step S25]: component function calculation step.
The component functions are calculated based on the equation (29).
[Step S26]: component function generating function relation
calculation step. The equations (18) to (19) are calculated.
[Step S27]: variable dependency analysis step.
The variable dependencies are calculated based on the equations (30) to (35).
[Step S28]: Output the result.
[Step S29]: data control step.
It exchanges data among the step S21 to the step S28 for their purpose.

One design example according to the block diagram of Fig.6 is described below.

Suppose the following logic circuit: let set data 1 represent likes or dislikes of each of $2^m$ users for each of K items; let set data 2 be L types of patterns among $2^K$ types of patterns indicative of likes or dislikes for each of the K items; and the logic circuit be for picking up the people corresponding to the L types of patterns (the set data 2) . That is a circuit receiving the user number of m bits and outputting "1" when the user satisfies it and "0" when the user does not satisfy it. Such exemplified circuit is designed by the block diagram of Fig.6 below.

The process proceeds under the control of the step 8. Firstly the step 1 transforms the setdata 1 of $2^m$ people tomcharacteristic logic functions, and the step 4 treats them as m component functions of a mapping A and calculates the generating function A. Likewise, the step 1 transforms the set data 2 of L elements to a characteristic indicating the selection of a single pattern, and the step 4 treats it as one component function of mapping B and calculates the generating function B. Next, the step 6 calculates the generating function of a composite mapping BA from the generating function A and the generating function B, and then calculates one component function of the generating function

In this manner, the logic function of the required circuit is obtained.

While the example can be designed by the processes of the step S21, step S24, step S26, step S28, there exist many examples using other steps above mentioned example

As described above, the logic function design method of the invention of Claim 8 is used for various logic designs by calculation and determination of Claim 5 to Claim 7 in a comprehensive manner in various fields of applications.

Next, examples illustrating the advantages of the encoding operation method of the invention remarkably are described.

[Example 1]

Suppose an old operation system defined with: a binary operation $F^1$: $\Omega^1_{in} \times \Omega^1_{in} \rightarrow \Omega^1_{OUT}$ having an input with a four element set $\Omega^1_{in}=(s,t,u,v,)$ and an output with a five element set $\Omega^1_{OUT}=(a,c,f,g,h)$; and another binary operation $F^2:\Omega^2\times\Omega^2\rightarrow\Omega^2$ having an input and output with a eight element set $\Omega^2=(a,b,c,d,e,f,g,h)$. To easily comprehend the advantages of the invention, considering that $F^1$ is a pseudo multiplier and $F^2$ is an pseudo adder, a calculation system of the original operation system performing product sum calculation (pseudo product sum calculation) is compared with the new operation system later.

$F^1$ is a pseudo multiplier and indicated by "*", and $F^2$ is a pseudo adder and indicated by "+". Plural pseudo additions are indicated by Σ as conventional. Then, the pseudo product sum operation is the following calculation:

$$(58)\quad Z = \sum_{k=1}^{K} X_k * Y_k$$

where $X_k,Y_k \in \Omega^1_{in}$, $Z \in \Omega^2$

Let the original operation system with the most general binary values. And, let $\Omega^1_{in} = B^2$ and $s\mapsto(0,0), t\mapsto(0,1), u\mapsto(1,0), v\mapsto(1,1)$; and let $\Omega^1_{OUT} = \Omega^2 = B^3$ and $a \mapsto(0,0,0), b\mapsto(0,0,1), c\mapsto(0,1,0), d\mapsto(0,1,1), e\mapsto(1,0,0), f\mapsto(1,0,1), g\mapsto(1,1,0), h\mapsto(1,1,1)$ . Then, $F^1$ is a binary operator having a four bit input and a three bit output, and $F^2$ is a six bit input and a three bit output. The truth table of this operator $F^1$ is shown in Fi.7, and the truth table of this operator $F^2$ is shown in Fig. 8. The circuits composed from the truth tables of Fig.7 and Fig.8 using a logic composition software product are shown in Fig . 9 and Fig.10. Fig.9 is the circuit diagram of $F^1$, and Fig.10 is the circuit diagram of $F^2$.

In this example 1, according to the first aspect of the invention, every original data set is extended to the old representation data set $B^3$, the old operations $F^1_O,F^2_O$ corresponding to the $F^1,F^2$ of the original operation system are treated as binary operations such as $F^1_O,F^2_O : B^3 \times B^3 \rightarrow B^3$, the new representation data set is set $B^3$ as well. Then encoding is non-redundant code of an isomorphic mapping type. That is, $\Phi : B^3 \rightarrow B^3$, $\Psi = \Phi^{-1}: B^3 \rightarrow B^3$. In this example, the new operation system is determined by the flow shown in Fig.11.

The flow of Fig.11 is as follows.

[Step S21]: The initialization is made with k=1, p=1. k is the number of inputs of the new operator. p is the number of bits off the new operator.

[Step S22] : p-th code Φ is generated ( replacement Φ is determined).

[Step S23] : The truth table of the pseudo adder is replaced with Φ to generate a new operator.

[Step S24] : A binary operators having a variable dependency equal or below k is generated.

[Step S25]: The inverse replacement ofΦ is applied to every candidate of the new pseudo multiplier and each result is compared to the corresponding point of the original pseudo multiplier.

[StepS26] : whether or not any candidate matches to it is determined, If any, the control proceeds to the step S27, and otherwise the control proceeds to the step S28.

[Step S27]: Whether or not the new operator is satisfactory is determined. If it is satisfactory then the control exits, and otherwise the control proceeds to the step S28.

[Step S28] : p=P is checked. If p=P is not true, the control proceeds to the step S29.

[Step S29] : After setting p=p+1, the control returns to the step S22, and the same process is repeated.

[Step S30]: Set p=1.

[Step S31]: k=K is checked. If k=K is not true, the control proceeds to the step S32. If k=K, the control exits.

[Step S32] : After setting k=k+1, the control returns to the step S22, and the same process is repeated.

Let $F^1_N,F^2_N$ be a group (plural equivalent groups exist) of new operators corresponding to $F^1,F^2$ of the original operation system, which are obtained by the result of the process shown in Fig.11. These $F^1_N,F^2_N$ are operations (mappings) such as $F^1_N,F^2_N : B^3 \times B^3 \rightarrow B^3$. The truth tables of those are shown in Fig.12 and Fig.13. Also, Fig.14 and Fig.15 are the truth tables of the encoder and decoder for the encoding.

The circuit diagrams of the circuits composed by the logic composing software product from the truth tables of Fig.12, Fig. 13, Fig.14, Fig.15 are shown in Fig.16, Fig.17, Fig.18, Fig.19 respectively.

Here, the flow of the new operation system determination of Fig.11 is described. In the example 1, the encoding is of a non-redundant encoding type, and the encoder Φ is a isomorphic mapping. It corresponds to the replacement among 8 elements (data) on $B^3$. The number of the replacements are 8!. Let P=8!. The P replacements are numbered.

Since both of the original addition and the addition of the old operation system are binary operations on $B^3$, they are treated same as each other. The replacement is applied to the input tree bits and output three bits. Fig.13 shows the replacements in the order of input. This is the truth table of the new operator for the pseudo addition produced by the encoding (replacement). The original pseudo multiplier is not directly extended to the old operation system. Differently, a candidate of the pseudo multiplier of the new operation system is outputted, and it is applied by the inverse replacement $\Phi^{-1}$ corresponding to each code to generate the pseudo multiplier of the old operation system corresponding to the candidate, and then the corresponding portions are matched to the truth table of the original multiplier. That is, the accordant candidate of the pseudo multiplier of the new operation system corresponds to what is encoded from the pseudo multiplier of the old operation system which is extended from the original operation system.

For the example described above, it is seen from the comparison of Fig.9 and Fg.16 in connection with the pseudo multiplier, and from the comparison of Fig.10 and Fig.17 in connection with the pseudo addition, that the circuitry of the operators of the new operation system is extremely simplified. Further, let □ be the number of NOT (inverter) elements and □ be delay time for evaluating the concrete advantages. Then, the element numbers and the delay times of the critical paths of $F^1,F^2,F^1_N,F^2_N$ are denoted with $\square^1$, $\square^2$, $\square^1_N$, $\square^2_N$, and $\Delta^1$, $\Delta^2$, $\Delta^1_N$, $\Delta^2_N$. The element numbers and the delay times of the critical paths of $\Phi,\Psi$ are denoted with $\square_\Phi$, $\square_\Psi$, and $\Delta_\Phi$, $\Delta_\Psi$. Then the element number to delay time table of the example is shown as Fig.20. In this figure, the element number and the delay time of a two input AND gate and a two input OR gate which are a general gate are 2□, 2□, and the element number and the delay time of a two input EXOR gate are 4□, 3□.

Further, hardware implementation of pseudo product sum operation of (58) is illustrated below.

Let consider that the pseudo product sum operators of the original operation system and the new operations system both are configured from the dedicated product sum circuit arranged in a tree structure as shown in the tree structure product sum operator block diagram of Fig.21, in which the multipliers marked with "*" are provided with the pseudo multipliers and the adders marked with "+" are provided with the pseudo adders. Then let evaluate these pseudo product sum operators.

Fig.21 is a block diagram corresponding to (58) with $K = 8 = 2^3$. When $K=2^L$ (L is a natural number), the multipliers denoted with "*" are arranged in parallel by 8, the adders denoted with ";" following the output of those multipliers are connected at each stage by $2^{L-1}$, $2^{L-2}$,...., 2, 1 to form a tree structure. Let denote the element number of the multiplier marked with the symbol "*" by $\square_*$, and denote its delay time by $\Delta_*$, also, the element number of the adder marked with the symbol "+" by $\square_+$, and its delay time by $\Delta_+$. (59) The element number of the product sum operator= $2^L\ \square_*+(2^L -1)\cdot\square_+$ (60) The delay time of the product sum operator=$\Delta_*+L\cdot\Delta_+$ When $K=8=2^3$, the element number of the original operation system is 2325□, and that of the new operation system is 100100□, and the delay time of the original operation system is 100□, and that of the new operation system is 21□. Considering only the pseudo product sum operators, the element number of the new operation system is about 1/23 of the original operation system, and the delay time of the new operation system is about 1/5 of the original operation system.

Practically, the new operation system should be evaluated together with the encoder and decoder.

The numbers of encoders and decoders can be implemented variously. Here let evaluate them with the circuit shown in Fig.22.

Fig. 22 illustrates an implemented circuit of the encoding operation method of the invention, in which an encoder $\Phi$ is provided for each of the $2K = 16$ pieces of input data $X_1,Y_1,\cdots,X_8,Y_8$, which are then translated into new representation data. The pseudo product sum operator of the new operation system configured as in Fig.21 calculates the product sum operation result $Z'$ as new representation data, which is in turn translated by the decoder $\Psi$ into the pseudo product sum result $Z$ of the original operation system to output it. This circuit A is shown as a black box, and has the same configuration and functions in the same manner as in Fig.21 to receive $X_1,Y_1,\cdots,X_8,Y_8$ and calculate $Z$. The element number is 467□, and the delay time is 36□. Both are reduced to a large extent.

As described above, according to the encoding operation method, not limitedly for closed operation systems but broadly for general operation system (original operation systems), an operation device whose element number and delay time are reduced can be realized. While the example shows the configuration with the base number r=2, the encoding operation method for multi value logic can be basically realized with the same flow.

The flow of Fig.11 shows only one algorithm of the logic design based on the invention, and there are many modified algorithms.

Also, the configuration of the tree structured product sum operation block diagram shown in Fig.21 in not limited to the pseudo product sum operation and can be applied for example to such a operator as performing a floating point operation, and Fig.22 can also show broadly a whole operation device having one or more encoders, one or more decoders, and one or more operators.

Also, an operation device can be realized which has CPU or a data control unit, and in which operation results by one or more new operators are stored in a memory still as new representation data without being transformed by the decoder, and are placed with other new representation data produced by one or more other calculation processes to be calculated following the calculation procedure.

[Example 2]

Next, an example with the original operation system having only 2 unary operations $G^1$, $G^2$ as defined on $B^2$ is illustrated such that the logic function design method using a generating function can be easily understood. Fig.23 is truth tables of $G^1$ and $G^2$. These unary operations $G^1$ and $G^2$ are mapping such as $G^1, G^2: B^2 \rightarrow B^2$. Let write component functions by $g^1{}_0(X)$, $g^1{}_1(X)$, and $g^2{}_0(X)$, $g^2{}_1(X)$. From the truth tables, $g^1{}_0(X)=x_1$, $g^1{}_1(X)=x_1 \cdot x_0$, and $g^2{}_0(X)=x_1 \cdot \overline{x_0}$, $g^2{}_1(X)=x_1 \cdot x_0$. The element number and delay time of $G^1$ are 2□, 2□, and the element number and delay time of $G^2$ are 5□, 3□. Also, the generating functions

$$\tilde{G}^1(Y,X)$$

and

$$\tilde{G}^2(Y,X)$$

of $G^1$ and $G^2$ are, from the definition equation(16), as follows:

$$\begin{aligned} \tilde{G}^1(Y,X) &= (y_0 \cdot g^1{}_0(x) \cup \overline{y_0} \cdot \overline{g^1{}_0(X)}) \cdot (y_1 \cdot g^1{}_1(x) \cup \overline{y_1} \cdot \overline{g^1{}_1(X)}) \\ &= (y_0 \cdot x_1 \cup \overline{y_0} \cdot \overline{x_1}) \cdot (y_1 \cdot x_1 \cdot x_0 \cup \overline{y_1} \cdot \overline{x_1 \cdot x_0}) \\ &= Y^0 \cdot X^0 \cup Y^0 \cdot X^1 \cup Y^1 \cdot X^2 \cup Y^3 \cdot X^3 \end{aligned} \tag{61}$$

Likewise,

$$\tilde{G}^2(Y,X) = Y^0 \cdot X^0 \cup Y^0 \cdot X^1 \cup Y^1 \cdot X^2 \cup Y^2 \cdot X^3 \tag{62}$$

Fig.24 shows these generating functions as Boolean value matrices.

The original operation system can not be further simplified by encoding with isomorphic mappings on $B^2$. Then, in the example 2, the new operation system is designed with three bit redundant encoding without non-code. Since when there is non-code, the characteristic logic function of the encoding domain $c(X')(X' \in B^3)$ is $c(X')=1$, the relation equation (1-b) between the encoder and the decoder is transformed to the equivalent equation as follows:

$$\begin{aligned} &\tilde{\Psi}(X,X') \cdot \tilde{\Phi}(X',X) = \tilde{\Phi}(X',X) \\ &\Leftrightarrow \tilde{\Psi}(X,X') \geq \tilde{\Phi}(X',X) \end{aligned} \tag{63}$$

From (63) and (2-b), the encoding design problem is equivalent to a box packing problem, considering

$$\tilde{\Psi}(X,X')$$

corresponding to each of four types of $X$ as a box in which eight types of miniterms are placed, to put the miniterms in the boxes so that there is no duplication and there is no empty box. When one way of box packing is determined, one of

$$\tilde{\Psi}(X,X')$$

is correspondingly determined.

Also, the corresponding expression of (3-b-1) can be transformed to the following equivalent expression:

$$\overline{\tilde{G}^q{}_O(Y,X)} \cdot \tilde{G}^q{}_N(Y',X') \cdot \tilde{\Psi}(Y,Y') \cdot \tilde{\Psi}(X,X') = 0 \quad (Y' \in B^3, q = 1,2)$$

$$(64) \quad \Leftrightarrow \overline{\tilde{G}^q{}_O(\Psi(X'),\Psi(Y'))} \cdot \tilde{G}^q{}_N(Y',X') = 0$$

$$\Leftrightarrow \tilde{G}^q{}_N(Y',X') \le \tilde{G}^q{}_O(\Psi(Y'),\Psi(X'))$$

$$\Leftrightarrow \tilde{G}^q{}_N(Y',X') \le \bigcup_Y \bigcup_X \tilde{G}^q{}_O(Y,X) \cdot \tilde{\Psi}(Y,Y') \cdot \tilde{\Psi}(X,X')$$

Further, (3-b-2) is always satisfied when $c(X')=1$. Thus, in the example 2, according to the flow of Fig. 25, two unary operations are generated in the order of simplicity with the simplest first, and it is checked whether or not the final expression of (64) is satisfied. And in that manner, the operation system is determined.

The flow of Fig.25 is as follows:

[Step S41]: A simple new operator candidate is generated.

[Step S42] : The generating function of the operator is configured.

[Step S43]: Codes are generated by the box packing.

[Step S44]: The satisfaction of the equation (64) is checked. Upon satisfaction, the control exits, and otherwise the control proceeds to the step S45.

[Step S45] : It is checked whether or not all codes are generated, and if yes, the control proceeds to the step S46, and otherwise the control returns to the step S43 and repeats the same process.

[Step S46]: A next new operator candidate is generated and the control returns to the step S42, and repeats the same process.

The result of the flow of Fig.25 is:

$$(65) \quad \tilde{\Psi}(X,X') = X^0 \cdot X'^6 \cup X^1 \cdot X'^2 \cup X^2 \cdot (X'^0 \cup X'^4) \cup X^3 \cdot (X'^1 \cup X'^3 \cup X'^5 \cup X'^7)$$

That is, for the encoding corresponding to the box packing such as one miniterm $X'^6$ is placed in the box

$$\tilde{\Psi}(0,X'),$$

one miniterm $X'^2$ is placed in the box

$$\tilde{\Psi}(1,X'),$$

two miniterms $X'^0$ and $X'^4$ are placed in

$$\tilde{\Psi}(2,X'),$$

four miniterms $X'^1$, $X'^3$, $X'^5$, $X'^7$ are placed in the box

$$\widetilde{\Psi}(3, X'),$$

the unary operations $G^1{}_N$ and $G^2{}_N$ of the new operation system satisfying the bottom expression of (64) is obtained whose component functions are $g^1{}_{N0}(X')=x'_0$, $g^1{}_{N1}(X')=\overline{x'_0}$, $g^1{}_{N2}(X')=x'_1$, $g^2{}_{N0}(X')=0$, $g^2{}_{N1}(X')=\overline{x'_0}$, $g^2{}_{N2}(X')=\overline{x'_1}$.

The element number and delay time of $G^1{}_N$ are □, □, and the element number and delay time of $G^2{}_N$ are 2□, □, and accordingly reduced to a large extent in comparison to $G^1$ of the original operation system. Note that, in this case, every generating function satisfying the equation (63) becomes a generating function of the encoder. For example, the following is an example of the generating function of the encoder:

$$(66)\ \widetilde{\Phi}(X', X) = X'^6 \cdot X^0 \cup X'^2 \cdot X^1 \cup X'^0 \cdot X^2 \cup X'^1 \cdot X^3$$

Here, verifying that the Ψ and $G^1{}_N$ satisfy the equation (64), the left side of (64) is:

$$\widetilde{G}^1{}_N(Y', X') = (y'_0 \cdot x'_0 \cup \overline{y'_0} \cdot \overline{x'_0}) \cdot (y'_1 \cdot \overline{x'_0} \cup \overline{y'_1} \cdot x'_0) \cdot (y'_2 \cdot x'_1 \cup \overline{y'_2} \cdot \overline{x'_1})$$
$$= Y'^2 \cdot X'^0 \cup Y'^1 \cdot X'^1 \cup Y'^6 \cdot X'^2 \cup Y'^5 \cdot X'^3 \cup Y'^2 \cdot X'^4 \cup Y'^1 \cdot X'^5 \cup Y'^6 \cdot X'^6 \cup Y'^5 \cdot X'^7$$

On the other hand, from (61) and (65), the right side of (64) is:

$$\bigcup_Y \bigcup_Y \widetilde{G}^1(Y, X) \cdot \widetilde{\Psi}(Y, Y') \cdot \widetilde{\Psi}(X, X')$$
$$= \widetilde{\Psi}(0, Y') \cdot \widetilde{\Psi}(0, X') \cup \widetilde{\Psi}(0, Y') \cdot \widetilde{\Psi}(1, X') \cup \widetilde{\Psi}(1, Y') \cdot \widetilde{\Psi}(2, X') \cup \widetilde{\Psi}(3, Y') \cdot \widetilde{\Psi}(3, X')$$
$$= Y'^6 \cdot X'^6 \cup Y'^6 \cdot X'^2 \cup Y'^2 \cdot (X'^0 \cup X'^4) \cup (Y'^1 \cup Y'^3 \cup Y'^5 \cup Y'^7) \cdot (X'^2 \cup X'^3 \cup X'^5 \cup X'^7)$$

Thus, the equation (64) is clearly satisfied.

Now, let illustrate the topology of the relation between the input and output of data of the operators of the example 2. Fig.26 illustrates the input/output topologies of the original operators $G^1$ and $G^2$. Let consider $G^1$. In Fig. 23, $G^1$ receives 0=(0,0) and outputs 0=(0,0), and receives 3=(1,1) and outputs 3=(1,1). The input and output relation in connection with 0=(0,0) and 3=(1,1) is self loop as topologies. Also, Fig.26 illustrates that the input 1=(0,1) outputs 0=(0,0), and the input 2=(1,0) outputs 1=(0,1). These topologies of the input/output relation completely correspond to the truth table. The same goes for $G^2$. Fig.27 illustrates the input/output topologies of the new operators $G^1{}_N$ and $G^2{}_N$ in the same manner. The topologies of Fig.26 are very different from those of Fig.27. But, based on the encoding, 0=(0,0,0) and 4=(1,0,0) belong to the same code [2] on $B^3$, and 1=(0,0,1), 3=(0,1,1), 5=(1,0,1), and 7=(1,1,1) belong to the same code [3]. Let consider what are tied by the ellipses, as groups. Then the input and output relation among the groups is illustrated in Fig.28. It is understood that the topologies of Fig.26 and Fig.28 are of the same type. The essence of the redundant encoding is that the topologies of the new operators having the same codes tied are of the same type as the topologies of the operators of the original operation system. Accordingly, the new operators can be designed so that they have the same topologies of the old ones. Fig.29 shows an example of the flow of determination of the new operation system using topologies (topology accordant new operation system determination flow). This is not limited to r=2, and is an efficient method for designing multi-value logics.

The flow of Fig.29 is as follows.

[Step S51]: The topology of the input/output relation of the original operator(s) is formed.

[Step S52]: A simple new operator candidate(s) is generated.

[Step S53] : The topology of the input/output relation of the new operator is formed.

[Step S54]: Codes are generated by the box packing.

[Step S55]: The topology tied by the codes of the input/output relation of the new operator with is generated.

[Step S56] : The topologies pf the original operation system and the new operation system are checked for their type coincidence. If the types are same, the control exits. Otherwise, the control proceeds to the step S57.

[Step S57]: It is checked whether or not every code has been generated. If every code has not generated yet, the control returns to the step S54 and repeats the same process. If every code has been generated, the control proceeds to the step S58.

[Step S58]: A next new operator candidate is generated, and the control returns to the step S53 and repeats the process.

As described above, the example 2 enables to design a new operation system based on the non-redundant encoding from the information of a original operation system by using the equivalent equations or relation to (1-b) , (2-b) , (3-b-1), (3-b-2) satisfying a generating function. Likewise, a new operation system can be designed from binary operations and T-nary operations of a original operation system based on (1-b) to (3-b-2) or the equivalent equations.

The description of the embodiments and examples is brought to completion.

It should be understood that the invention is not limited to the embodiments described above and can be modified in a variety of manners not departing from the sprit of the invention.

## Claims

**1.** An operation device having one or more encoders, operation means for operating one or more outputs of the one or more encoders, and one or more decoders for decoding one or more outputs of the operationmeans, and replacing one or more operations of an original operation system defined on first representation data, with one or more operations of a new operation system of the operation means defined on second representation data, **characterized in that**:

a set of the first representation data of the original operation system is a set $B_r^n$ (a direct product of n sets $B_r$ of r values) with a base number of r and a word length of n such as to satisfy $\max\{|\Omega_G{}^q in|, |\Omega_F{}^p in|, |\Omega_H{}^s in|, |\Omega_G{}^q out|, |\Omega_F{}^p out|, |\Omega_H{}^s out|\} \leq r^n$,

where $|\Omega_G{}^q in|$, $|\Omega_F{}^p in|$, $|\Omega_H{}^s in|$, $|\Omega_G{}^q out|$, $|\Omega_F{}^p out|$, $|\Omega_H{}^s out|$ are cardinal numbers of one or a plurality (Q+P+S>=1) of finite sets $\Omega_G{}^q in$, $\Omega_F{}^p in$, $\Omega_H{}^s in$, and $\Omega_G{}^q out$, $\Omega_F{}^p out$, $\Omega_H{}^s out$ for input space and output space of the original operation system in which original operation system Q unary operations $G^q$: $\Omega_G{}^q in \rightarrow \Omega_G{}^q out$ ($q$ =1,2,⋯,Q,), and/or P binary operations $F^p$:$\Omega_F{}^p in \times \Omega_F{}^p in \rightarrow \Omega_F{}^p out$ ($p$=1,2,⋯,$P$), and/or S T-nary operations $F^p$:$\Omega_F{}^p in \times \Omega_F{}^p in \rightarrow \Omega_F{}^p out$ ($p$=1,2,⋯,$P$) are defined;

unless $|\Omega in| = r^n$ for a cardinal number $|\Omega in|$ of a set of data $\Omega in$ ( any of $\Omega_G{}^q in$, $\Omega_F{}^p in$, $\Omega_H{}^s in$) of input space of any of the operation of the original operation system, relationships for $r^n$-$|\Omega|$ undefined elements are added to the any of the operation of the original operation system;

the Q unary operations $G^q$ of the original operation system are extended to unary operations $G^q{}_O$: $B_r^n \rightarrow B_r^n$ ($q$=1,2,⋯,$Q$), the P binary operations $F^p$ is extended to binary operations $F^p{}_O$: $B_r^n \times B_r^n \rightarrow B_r^n$ ($p$=1,2,⋯,$P$), and the S T-nary operations $H^s$ is extended to T-nary operations $H^s{}_O$: $B_r^n \times B_r^n \times \cdots \times B_r^n \rightarrow B_r^n$ (the number of direct products is T, $s$ = 1,2,⋯,$S$);

the second representation data is data on a set $B_r^m$ ($m \geq n$);

the one or more encoders function as injective mappings $\Phi : B_r^n \rightarrow B_r^m$;

the one or more decoders function as surjective mappings $\Psi : B_r^m \rightarrow B_r^n$;

the operation means operates as one or more unary operations $G^q{}_N$: $B_r^m \rightarrow B_r^m$ of the new operation system corresponding to $G^q{}_O$, as one or more binary operations $F^p{}_N$: $B_r^m \times B_r^m \rightarrow B_r^m$ of the new operation corresponding to $F^p{}_O$, and/or as one or more T-nary operations $H^s{}_N$: $B_r^m \times B_r^m \times \cdots \times B_r^m \rightarrow B_r^m$ of the new operation system corresponding to $H^s{}_O$;

whereby all operations of the original operation system and all operations, encoders and decoders of the new operation system are related to mappings of an r- value logic type having plural inputs and outputs; and,

a code $[X]$($[X] \subset B_n^m$) corresponding to every one of X on $B_r^n$ satisfies following expressions (1) to (5),

$$(1)\ \Phi(X) \in [X] \subset B_r{}^m \text{ (for } \forall X \in B_r{}^n)$$

$$(2)\ \Psi([X]) = X \text{ (for } \forall X \in B_r^{\,n})$$

$$(3)\ Y=G^q{}_O(X) \Leftrightarrow [Y] \supset G^q{}_N([X]) \text{ (for } \forall X,Y \in B_r^{\,n},\ \forall q)$$

$$(4)\ Z=F^p{}_O(X,Y) \Leftrightarrow [Z] \supset F^p{}_N([X],[Y]) \text{ (for } \forall X,Y,Z \in B_r^{\,n},\ \forall p)$$

$$(5)\ Y=H^s{}_O(X_1,\cdots,XT) \Leftrightarrow [Y] \supset H^s{}_N([X_1],\cdots,[X_T]) \text{ (for } \forall X_1,\cdots,X_T,Y \in B_r^{\,n},\ \forall s).$$

**2.** An operation device having one or more encoders, operation means for operating one or more outputs of the one or more encoders, and one or more decoder for one or more outputs of the operation means, and replacing one or more operations of an original operation system defined on first representation data, with one or more operations of a new operation system of the operation means defined on second representation data, **characterized in that**:

a set of the first representation data of the original operation system is a set $B^n_r$ (a direct product of n sets $B_r$ of r values) with a base number of r and a word length of n such as to satisfy max{$|\Omega_G{}^q in|$,$|\Omega_F{}^p in|$,$|\Omega_H{}^s in|$, $|\Omega_G{}^q out|$,$|\Omega_F{}^p out|$,$|\Omega_H{}^s out|$}$\leq r^n$, where $|\Omega_G{}^q in|$, $|\Omega_F{}^p in|$, $|\Omega_H{}^s in|$, $|\Omega_G{}^q out|$, $|\Omega_F{}^p out|$, $|\Omega_H{}^s out|$ are cardinal numbers of one or a plurality (Q+P+S□1) of finite sets $\Omega_G{}^q in$, $\Omega_F{}^p in$, $\Omega_H{}^s in$, and $\Omega_G{}^q out$, $\Omega_F{}^p out$, $\Omega_H{}^s out$ for input space and output space of the original operation system in which original operation system Q unary operations $G^q$: $\Omega_G{}^q in \rightarrow \Omega_G{}^q out$ ($q$ = 1,2,⋯,Q,), and/or P binary operations $F^p$:$\Omega_F{}^p in \times \Omega_F{}^p in \rightarrow \Omega_F{}^p out$ ($p$=1,2,⋯,$P$), and/or S T-nary operations $F^p$:$\Omega_F{}^p in \times \Omega_F{}^p in \rightarrow \Omega_F{}^p out$ ($p$=1,2,⋯,$P$) are defined;

unless $|\Omega in|=r^n$ for a cardinal number $|\Omega in|$ of a set of data $\Omega in$ ( any of $\Omega_G{}^q in$, $\Omega_F{}^p in$, $\Omega_H{}^s in$) of input space of any of the operation of the original operation system, relationships for $r^n$-$|\Omega|$ undefined elements does are added to the any of the operation of the original operation system;

the Q unary operations $G^q$ of the original operation system are extended to unary operations $G^q{}_O$: $B_r{}^n \rightarrow B_r{}^n$ ($q$=1,2,⋯,Q), the P binary operations $F^p$ is extended to binary operations $F^p{}_O$: $B^n_r \times B^n_r \rightarrow B^n_r$ ($p$=1,2,⋯,$P$), and the S T-nary operations $H^s$ is extended to T-nary operations $H^s{}_O$: $B^n_r \times B^n_r \times \cdots \times B^n_r \rightarrow B^n_r$ (the number of direct products is T, $s$=1,2,⋯,$S$);

the second representation data is data on a set $B^m_r$ ($m \geq n$);

the one or more encoders function as injective mappings $\Phi$ : $B_r{}^n \rightarrow B_r{}^m$;

the one or more decoders function as surjective mappings $\Psi$ : $B_r{}^m \rightarrow B_r{}^n$;

the operation means operates as one or more unary operations $G^q{}_N$: $B^m_r \rightarrow B^m_r$ of the new operation system corresponding to $G^q{}_O$, as one or more binary operations $F^p{}_N$:$B^m_r \times B^m_r \rightarrow B^m_r$ of the new operation corresponding to $F^p{}_O$, and/or as one or more T-nary operations $H^s{}_N$:$B^m_r \times B^m_r \times \cdots \times B^m_r \rightarrow B^m_r$ of the new operation system corresponding to $H^s{}_O$;

whereby all operations of the original operation system and all operations, encoders and decoders of the new operation system are related to mappings of an r- value logic type having plural inputs and outputs; and,

a code $[X]$($[X] \subset B^m_r$) corresponding to every one of X on $B_r{}^n$ satisfies following expressions (1c) to (5c),

$$(1c)\ \chi'_{[X]}(\Phi(X)) = 1 \text{ (for } \forall X \in B_r^{\,n})$$

$$(2c)\ \chi_X(\Psi([X])) = 1 \text{ (for } \forall X \in B_r^{\,n})$$

$$(3c)\ \chi'_{[GqO(X)]}(G^q{}_N([X])) = 1 \text{ (for } \forall X \in B_r^{\,n},\ \forall q)$$

$$(4c)\ \chi'_{[F^{p}{}_{O(X,Y)}]}(F^{p}{}_{N}([X],[Y]) = 1\ (\text{for } \forall X,Y\in B_r^{\ n},\ \forall p)$$

$$(5c)\ \chi'_{[H^{s}{}_{O(X_1,\cdots X_T)}]}(H^{s}_{N}([X_1],\cdots,[X_T]) = 1\ (\text{for } \forall X_1,\cdots,X_T \in B_r^{\ n},\ \forall s).$$

**3.** An operation device design method comprising computer executed steps of:

generating a code $[X]([X]\subset B^m_r)$ corresponding to each one of X on $B^n_r$ satisfies following expressions (1) and (2),

$$(1)\ \Phi(X)\in[X]\subset B^m_r\ (\text{for } \forall X\in B^n_r)$$

$$(2)\ \Psi([X])=X\ (\text{for } \forall X\in B^n_r)$$

where a set of the first representation data of the original operation system is a set $B^n_r$ (a direct product of n sets $B_r$ of r values) with a base number of r and a word length of n such as to satisfy max{$|\Omega_G{}^q in|$,$|\Omega_F{}^p in|$, $|\Omega_H{}^s in|$,$|\Omega_G{}^q out|$,$|\Omega_F{}^p out|$,$|\Omega_H{}^s out|$}$\leq r^n$, where $|\Omega_G{}^q in|$, $|\Omega_F{}^p in|$, $|\Omega_H{}^s in|$, $|\Omega_G{}^q out|$, $|\Omega_F{}^p out|$, $|\Omega_H{}^s out|$ are cardinal numbers of one or a plurality (Q+P+S□1) of finite sets $\Omega_G{}^q in$, $\Omega_F{}^p in$, $\Omega_H{}^s in$, and $\Omega_G{}^q out$, $\Omega_F{}^p out$, $\Omega_H{}^s out$ for input space and output space of the original operation system in which original operation system Q unary operations $G^q:\Omega_G{}^q in\rightarrow\Omega_G{}^q out$ ($q$=1,2,⋯,Q,), and/or P binary operations $F^p:\Omega_F{}^p in\times\Omega_F{}^p in\rightarrow\Omega_F{}^p out$ ($p$=1,2,⋯,$P$), and/or S T-nary operations $F^p:\Omega_F{}^p in\times\Omega_F{}^p in\rightarrow\Omega_F{}^p out$ ($p$=1,2,⋯,$P$) are defined; unless $|\Omega in|=r^n$ for a cardinal number $|\Omega in|$ of a set of data $\Omega in$ ( any of $\Omega_G{}^q in$, $\Omega_F{}^p in$, $\Omega_H{}^s in$) of input space of any of the operation of the original operation system, relationships for $r^n$-$|\Omega|$ undefined elements does are added to the any of the operation of the original operation system; the Q unary operations $G^q$ of the original operation system are extended to unary operations $G^q{}_O$: $B^n_r \rightarrow B^n_r$ ($q$=1,2,⋯,$Q$), the P binary operations $F^p$ is extended to binary operations $F^p{}_O$: $B^n_r \times B^n_r \rightarrow B^n_r$ ($p$=1,2,⋯, $P$), and the S T-nary operations $H^s$ is extended to T-nary operations $H^s{}_O$: $B^n_r \times B^n_r \times\cdots\times B^n_r \rightarrow B^n_r$ (the number of direct products is T, $s$=1,2,⋯,$S$); the second representation data is data on a set $B^m_r$($m\geq n$); one or more encoders function as injective mappings $\Phi : B^n_r \rightarrow B^m_r$; one or more decoders function as surjective mappings $\Psi : B^m_r \rightarrow B^n_r$; one or more unary operations of the new operation system corresponding to $G^q{}_O$ are such as $G^q{}_N$: $B^m_r \rightarrow B^m_r$; one or more binary operations of the new operation system corresponding to $F^p{}_O$ are such as of the new operation system corresponding to $G^q{}_O$, as one or more binary operations $F^p{}_N$: $B^m_r \times B^m_r \rightarrow B^m_r$ of the new operation corresponding to $F^p{}_O$; one or more T-nary operations of the new operation system corresponding to $H^s{}_O$ are such as $H^s{}_N$: $B^m_r \times B^m_r \times\cdots\times B^m_r \rightarrow B^m_r$; whereby all operations of the original operation system and all operations, encoders and decoders of the new operation system are related to mappings of an r- value logic type having plural inputs and outputs;
generating one or more operations of the new operation system; and,
selecting, among the one or more operations thus generated, one or more operations satisfying following expressions,

$$(3)\ Y = G^{q}{}_{O}(X)\Leftrightarrow[Y]\supset G^{q}{}_{N}([X])\ (\text{for } \forall X,Y\in B_r^{\ n},\ \forall q)$$

$$(4)\ Z = F^{p}{}_{O}(X,Y)\Leftrightarrow[Z]\supset F^{p}{}_{N}([X],[Y])\ (\text{for } \forall X,Y,Z\in B_r^{\ n},\ \forall p)$$

(5) $Y=H^{s}{}_{O}(X_1,\cdots X_T)\Leftrightarrow[Y]\supset H^{s}{}_{N}([X_1],\cdots,[X_T])$ (for $\forall X_1,\cdots,X_T,Y\in B_r{}^n$, $\forall s$).

**4.** An operation device design method comprising computer executed steps of:

generating a code $[X]([X]\in B^m_n)$ corresponding to each one of X on $B^n_r$ satisfies following expressions (1) and (2),

$$\text{(1c)}\ \chi'_{[X]}(\Phi(X))=1\ (\text{for}\ \forall X\in B_r{}^n)$$

$$\text{(2c)}\ \chi_X(\Psi([X]))=1\ (\text{for}\ \forall X\in B_r{}^n)$$

where a set of the first representation data of the original operation system is a set $B^n_r$ (a direct product of n sets $B_r$ of r values) with a base number of r and a word length of n such as to satisfy $\max\{|\Omega_G{}^q in|,|\Omega_F{}^p in|,|\Omega_H{}^s in|,|\Omega_G{}^q out|,|\Omega_F{}^p out|,|\Omega_H{}^s out|\}\leq r^n$ , where $|\Omega_G{}^q in|$, $|\Omega_F{}^p in|$, $|\Omega_H{}^s in|$, $|\Omega_G{}^q out|$, $|\Omega_F{}^p out|$, $|\Omega_H{}^s out|$ are cardinal numbers of one or a plurality (Q+P+S□1) of finite sets $\Omega_G{}^q in$, $\Omega_F{}^p in$, $\Omega_H{}^s in$, and $\Omega_G{}^q out$, $\Omega_F{}^p out$, $\Omega_H{}^s out$ for input space and output space of the original operation system in which original operation system Q unary operations $G^q:\Omega_G{}^q in\rightarrow\Omega_G{}^q out$ ($q$ =1,2,⋯,Q,), and/or P binary operations $F^p:\Omega_F{}^p in\times\Omega_F{}^p in\rightarrow\Omega_F{}^p out$ ($p$=1,2,⋯,$P$), and/or S T-nary operations $F^p$: $\Omega_F{}^p in\times\Omega_F{}^p in\rightarrow\Omega_F{}^p out$ ($p$=1,2,⋯,$P$) are defined; unless $|\Omega in|=r^n$ for a cardinal number $|\Omega in|$ of a set of data $\Omega in$ ( any of $\Omega_G{}^q in$, $^*\Omega_F{}^p in$, $\Omega_H{}^s in$) of input space of any of the operation of the original operation system, relationships for $r^n$-$|\Omega|$ undefined elements does are added to the any of the operation of the original operation system; the Q unary operations $G^q$ of the original operation system are extended to unary operations $G^q{}_O$: $B^n_r\rightarrow B^n_r$ ($q$=1,2,⋯,Q), the P binary operations $F^p$ is extended to binary operations $F^p{}_O$: $B^n_r\times B^n_r\rightarrow B^n_r$ ($p$=1,2,⋯,$P$), and the S T-nary operations $H^s$ is extended to T-nary operations $H^s{}_O$: $B^n_r\times B^n_r\times\cdots\times B^n_r\rightarrow B^n_r$ (the number of direct products is T, $s$=1,2,⋯,$S$); the second representation data is data on a set $B^m_r$($m\geq n$); one or more encoders function as injective mappings $\Phi: B^n_r\rightarrow B^m_r$; one or more decoders function as surjective mappings $\Psi: B^m_r\rightarrow B^n_r$; one or more unary operations of the new operation system corresponding to $G^q{}_O$ are such as $G^q{}_N$: $B^m_r\rightarrow B^m_r$; one or more binary operations of the new operation system corresponding to $F^p{}_O$ are such as of the new operation system corresponding to $G^q{}_O$, as one or more binary operations $F^p{}_N$: $B^m_r\times B^m_r\rightarrow B^m_r$ of the new operation corresponding to $F^p{}_O$; one or more T-nary operations of the new operation system corresponding to $H^s{}_O$ are such as $H^s{}_N$: $B^m_r\times B^m_r\times\cdots\times B^m_r\rightarrow B^m_r$; whereby all operations of the original operation system and all operations, encoders and decoders of the new operation system are related to mappings of an r- value logic type having plural inputs and outputs;

generating one or more operations of the new operation system; and,

selecting, among the one or more operations thus generated, one or more operations satisfying following expressions,

$$\text{(3c)}\ \chi'_{[G^q{}_O(X)]}(G^q{}_N([X]))=1\ (\text{for}\ \forall X\in B_r{}^n,\ \forall q)$$

$$\text{(4c)}\ \chi'_{[F^p{}_O(X,Y)]}(F^p{}_N([X],[Y])=1\ (\text{for}\ \forall X,Y\in B_r{}^n,\ \forall p)$$

(5c) $\chi'_{[H^s O(X_1,\cdots X_T)]}(H^s{}_N(X_1],\cdots[X_T])=1$ (for $\forall X_1,\cdots,X_T \in B_r{}^n$, $\forall s$).

**5.** A logic function design method, **characterized in that**: finite sets are treated as sets on $B^n$; (6) a characteristic function $\chi_S(X)(S \subseteq B^n, X \in B^n)$ of an arbitrary subset S on $B^n$ is treated as one n-variable Boolean function (characteristic logic function);

(7) each element of a set is related to a miniterm of $B^n$; following relation expressions (8), (9), and (10) are satisfied where a characteristic logic function of a subset $S(S \subset B^n)$ of $B^n$ is denoted with $\chi_S(X)(X \in B^n)$, a characteristic logic function of a subset $T(T \subset B^m)$ of $B^m$ is denoted with $\chi'_T(Y)(Y \in B^m)$, and an image of a subset S of $B^n$ by a mapping $F : B^n \to B^m$ is denoted with $F(S)$ ,

$$(8) \quad \chi_S(X) = \bigcup_{Q \in S} \chi_Q(X) = \bigcup_{Q \in S} X^Q$$

$$(9) \quad \chi'_{F(S)}(Y) = \bigcup_{Q \in S} Y^{F(Q)}$$

$$(10) \quad \chi'_{F(S)}(Y) = \bigcup_{X} Y^{F(X)} \cdot \chi_S(X) ;$$

following relation expressions (11) to (14) are satisfied for a subset $S,T \subset B^n$ of $B^n$,

$$(11) \ \chi_S(X) \cdot \chi_T(X)=0 \ (\textit{for } \forall X \in B^n) \Leftrightarrow S \cap T = \phi$$

$$(12) \ \chi_{S \cap T}(X)=\chi_S(S) \cdot \chi_T(X)$$

$$(13) \ \chi_{S \cup T}(X) = \chi_S(S) \cup \chi_T(X)$$

$$(14) \ \overline{\chi_S(X)} \cdot \chi_T(X)=0 \ (\textit{for } \forall X \in B^n) \Leftrightarrow S \supset T;$$

further **characterized by** computer executed steps of:

inputting relation among sets;
translating the inputted relation among the sets to expressions of characteristic logic functions based on the relation expressions (8) to (14); and,
determining whether or not the translated characteristic logic functions are satisfied.

**6.** A logic function design method, **characterized in that**:

a mapping $F : B^n \to B^m$ composed of m n-variable Boolean functions $f_j(X)$ ( where $X=(x_1,x_2,\cdots,x_n)$, j=1, 2,$\cdots$, $m$) defined on binary Boolean algebra B={0,1) are treated in a lump by a generating function defined with a following expression (16),

$$(16) \quad \tilde{F}(Y,X) = Y^{F(X)} = \bigcap_{j=1}^{m} \{y_j f_j(X) \cup \overline{y}_j \overline{f_j(X)}\}$$

(where $Y = (y_1, y_2, \cdots, y_m)$);

for an arbitrary function $g(Y)$ of $Y \in B^n$, the function $g(Y)$ is determined as a miniterm when a following expression (18) is satisfied,

$$(18)\quad \bigcup_Y g(Y) \cdot \tilde{F}(Y,X) = g(F(X)),$$

or, for an identity translation $I:B^n \rightarrow B^n$, a following expression (19) are satisfied,

$$(19)\quad \bigcup_Y g(Y) \cdot \tilde{I}(Y,X) = g(X),$$

or relation of following expressions (20), (21), (22) and (27) among component functions $f_j(X)$ a mapping F and the generation function are satisfied,

$$(20)\quad f_j(X) = \bigcup_Y y_j \cdot \tilde{F}(Y,X)$$

$$(21)\quad \overline{f_j(X)} = \bigcup_Y \overline{y_j} \cdot \tilde{F}(Y,X)$$

$$(27)\quad \tilde{F}(Y,X) \cdot \tilde{F}(Z,X) = \tilde{F}(Y,X) \cdot \tilde{I}(Y,Z),$$

or, following expressions (15) and (17) where a composite mapping of a mapping $F : B^n \rightarrow B^m$ and a mapping $G : B^m \rightarrow B^l$ is denoted with $R : B^n \rightarrow B^l$,

$$(15)\quad Z^{R(X)} = \bigcup_Y Z^{G(Y)} \cdot Y^{F(X)}$$

$$(17)\quad \tilde{R}(Z,X) = \bigcup_Y \tilde{G}(Z,Y) \cdot \tilde{F}(Y,X),$$

or, for the characteristic logic function with $\Omega = B^n$ following relation expressions (22) and (23) are satisfied,

$$(22)\quad \bigcup_Y \tilde{F}(Y,X) = \chi_\Omega(X) = 1$$

$$(23)\quad \bigcup_X \tilde{F}(Y,X) = \chi'_{F(\Omega)}(Y),$$

or, for an isomorphic mapping $\Phi:\Omega\rightarrow\Omega$ on $\Omega=B^n$, following relation expressions (24), (25), and (26) are satisfied from definition (16) of the generating function, where an inverse mapping is denoted by $\Phi^{-1}: \Omega\rightarrow\Omega$,

$$(24)\quad \tilde{\Phi}^{-1}(X,Y)=\tilde{\Phi}(Y,X)\ (\text{for } X,Y\in\Omega)$$

$$(25)\quad \phi^{-1}{}_i(X)=\bigcup_Y y_i\cdot\tilde{\Phi}(X,Y)$$

$$(26)\quad \bigcup_Z \tilde{\Phi}^{-1}(X,Z)\cdot\tilde{\Phi}(Z,Y)=\bigcup_Z \tilde{\Phi}(X,Z)\cdot\tilde{\Phi}(Z,Y)=\tilde{I}(X,Y)\ (\text{for } \forall X,Y,Z\in\Omega),$$

or, for an arbitrary function $g(Y)$ of $Y\in B^n$ , a following relation expression (28) is satisfied,

$$(28)\quad \bigcup_Y \overline{\tilde{I}(Z,Y)}\cdot g(Y)=\overline{g(Z)};$$

and,

$$\tilde{F}(Y,X)$$

is determined as a generating function of a mapping $B^n\rightarrow B^m$, when a following relation expression (29) is satisfied,

$$(29)\quad \bigcup_Y \overline{\tilde{I}(Z,Y)}\cdot\tilde{F}(Y,X)=\overline{\tilde{F}(Z,X)}\ (\text{for } \forall Y,Z\in B^m,\ \ \forall X\in B^n);$$

the method further comprising computer executed steps of:

inputting each component function or a generating function of each mapping;
calculating the each component function and/or the generating function based on the expression (16);
calculating the expressions (18) to (29); and,
whereby .processes and determinations in connection with each mapping is treated in lump.

**7.** A logic function design method, **characterized in that**:

dependencies of a logic function $f(X)$ with variables $x_1,x_2,\cdots,x_n$ are analyzed by determining whether or not a following relation expression (30) is satisfied,

$$(30)\quad f(X)\cdot\overline{f(Y)}\cdot\Delta(X,Y)=0,$$

or, by determining whether or not a following relation expression (31) using a generating function of a mapping is satisfied for component function for $f_j(X)$ ($j = 1,2,\cdots,m$) of a mapping $F : B^n\rightarrow B^m$,

$$(31)\ \widetilde{F}(X,A)\cdot\widetilde{F}(Y,B)\cdot x_j\cdot\overline{y_j}\cdot\Delta_j(A,B)=0\ ,$$

or, particularly, by determining whether or not a following relation expression (32) is satisfied which corresponds to a case where $\Delta(X,Y)$ is

$$\Delta(X,Y)=\widetilde{I}(X,Y^i)$$

in the expression,

$$(32)\quad f(X)\cdot\overline{f(Y)}\cdot\widetilde{I}(X,Y^i)=0\ ,$$

or, by determining whether or not a following relation expression (33) is satisfied, which corresponds to a case where

$$\Delta(X,Y)=\widetilde{I}(X,Y^L)\ (\text{for}\ \forall L\subset\Theta)\ ,$$

$$(33)\ f(X)\cdot\overline{f(Y)}\cdot\widetilde{I}(X,Y^L)=0\quad(\mathit{for}\quad\forall L\subset\Theta)\ ,$$

or, by determining whether or not a following relation expression (34) is satisfied, which corresponds to a case where

$$\Delta(X,Y)=\bigcap_l(x_l\cdot y_l\cup\overline{x_l}\cdot\overline{y_l}\cup\overline{\theta^l})\ ,$$

$$(34)\ f(X)\cdot\overline{f(Y)}\cdot\bigcap_l(x_l\cdot y_l\cup\overline{x_l}\cdot\overline{y_l}\cup\overline{\theta^l})=0$$

or, by determining whether or not a following relation expression (35) is satisfied, which corresponds to a case where $\Delta_j(A,B)$ in the expression (31) is

$$\Delta_j(A,B)=\bigcap_l(a_l\cdot b_l\cup\overline{a_l}\cdot\overline{b_l}\cup\theta_j{}^l)\ ,$$

$$(35)\ \widetilde{F}(X,A)\cdot\widetilde{F}(Y,B)\cdot x_j\cdot\overline{y_j}\cdot\bigcap_l(a_l\cdot b_l\cup\overline{a_l}\cdot\overline{b_l}\cup\theta_j{}^l)=0\ ;$$

and,
dependencies of $f_j(X)$ of the variables $x_1,x_2,\cdots,x_n$ is analyzed in a lump by using the generating function;
the method further comprising computer executed steps of:

inputting each component function or a generating function of each mapping; and, analyzing the variable dependencies based on the expressions (30)~(35).

**8.** The logic function design method of either of Claim 5 to Claim 7, further comprising computer executed steps of:

inputting relation among sets;
translating the inputted relation among the sets to characteristic logic functions using the relation expressions (8) to (14);
determining whether or not the resultant characteristic logic functions are satisfied;
inputting component functions and/or a generating function of each mapping;
calculating the each component function and/or the generating function based on the expression (16);
calculating the expressions (18) to (29);
analyzing variable dependencies based on the relation expressions (30) to (35); and,
whereby .processes and determinations in connection with each mapping is treated in lump.

**9.** The logic function design method of Claim 3 or Claim 4,
wherein, the base number r is r=2, and following expressions (1-b) to (5-b-2) are used for the encoding conditions, where component functions of the one or more operations of the old operation system, and the one or more operations, one or more encoders and one or more decoders are expressed by $G^q{}_O : g^q_i{}_O(X)$, $F^p{}_O : f^p_l O(X,Y)$, $H^s{}_O : h^s_i{}_O(X_1,X_2,\cdots X_T)$ and $G^q{}_N : g^q_j{}_N(X')$, $F^p{}_N : f^p_j{}_N(X',Y')$, $H^s{}_N : h^s_j{}_N(X'_1,X'_2,\cdots X'_T)$, $\Phi{:}\phi_j(X)$, $\Psi : \psi_i(X')$, and a characteristic function $\chi_C(X')$ of a code domain is expressed by $c(X')$ with $i=1,2,\cdots,n$, $X,Y,Z,X_1,X_2,\cdots,X_T \in B^n$, $j=1,2,\cdots,m$ $X',Y',Z',X',X_2,\cdots,X'_T \in B^m$,

$$\text{(1-b)}\quad \tilde{\Psi}(X,X')\cdot c(X')\cdot\tilde{\Phi}(X',X)=\tilde{\Phi}(X',X)$$

$$\text{(2-b)}\quad \bigcup_{X'}\tilde{\Phi}(X',X)\cdot\tilde{\Phi}(X',Y)=\tilde{I}(X,Y)$$

$$\text{(3-b-1)}\quad \overline{\tilde{G}^q{}_O(Y,X)}\cdot\tilde{G}^q{}_N(Y',X')\cdot\tilde{\Psi}(Y,Y')c(Y')\cdot\tilde{\Psi}(X,X')c(X')=0$$

$$\text{(3-b-2)}\quad \overline{c(Y')}\cdot c(X')\cdot\tilde{G}^q{}_N(Y',X')=0$$

$$\text{(4-b-1)}\quad \overline{\tilde{F}^p{}_O(Z,Y,X)}\cdot\tilde{F}^p{}_N(Z',Y',X')\cdot\tilde{\Psi}(Z,Z')c(Z')\cdot\tilde{\Psi}(Y,Y')c(Y')\cdot\tilde{\Psi}(X,X')c(X')=0$$

$$\text{(4-b-2)}\quad \overline{c(Z')}\cdot c(Y')\cdot c(X')\cdot\tilde{F}^p{}_N(Z',Y',X')=0$$

(5-b-1)

$$\overline{\tilde{H}^s{}_O(Y,X_1,\cdots,X_T)}\cdot\tilde{H}^s{}_N(Y',X'_1,\cdots,X'_T)\cdot\tilde{\Psi}(Y,Y')c(Y')\cdot\tilde{\Psi}(X_1,X'_1)c(X'_1)\cdots\tilde{\Psi}(X_T,X'_T)c(X'_T)=0$$

(5-b-2) $\overline{c(Y')}\cdot c(X'_1)\cdot\cdots\cdot c(X')\cdot\tilde{H}^s{}_N(Y',X'_1,\cdots,X'_T)=0$ .

**10.** The logic function design method of Claim 9, wherein further conditions for simplifying the one or more operators of the new operation system are imposed in addition to the expressions (1-b) to (5-b-2), and circuitry of the new operation system are simplified by designing the one or more encoders, the one or more decoders and the one or more operators thereunder.

**11.** The logic function design method of Claim 10, wherein a following condition (48) is imposed to the unary operations,

$$(48)\quad \tilde{G}^q{}_N(X',A')\cdot\tilde{G}^q{}_N(Y',B')\cdot x'_j\cdot\overline{y'_j}\cdot\bigcap_l(a'_l\cdot b'_l\cup\overline{a'_l}\cdot\overline{b'_l}\cup\overline{\lambda^q{}_j{}^l})=0$$

a following condition (49) is imposed to the binary operations,

$$(49)\quad \tilde{F}^p{}_N(X',A',C')\cdot\tilde{F}^p{}_N(Y',B',C')\cdot x'_j\cdot\overline{y'_j}\cdot\bigcap_l(a'_l\cdot b'_l\cup\overline{a'_l}\cdot\overline{b'_l}\cup\overline{\theta_1{}^p{}_j{}^l})=0$$

$$\tilde{F}^p{}_N(X',C',A')\cdot\tilde{F}^p{}_N(Y',C',B')\cdot x'_j\cdot\overline{y'_j}\cdot\bigcap_l(a'_l\cdot b'_l\cup\overline{a'_l}\cdot\overline{b'_l}\cup\overline{\theta_2{}^p{}_j{}^l})=0$$

a following variable dependency condition (50) is imposed to the T-nary operations,

(50)

$$\tilde{H}^s{}_N(X',A',C'_2,\cdots,C'_T)\cdot\tilde{H}^s{}_N(Y',B',C'_2,\cdots,C'_T)\cdot x'_j\cdot\overline{y'_j}\cdot\bigcap_l(a'_l\cdot b'_l\cup\overline{a'_l}\cdot\overline{b'_l}\cup\overline{\mu_1{}^s{}_j{}^l})=0$$

$$\tilde{H}^s{}_N(X',C'_1,A',\cdots,C'_T)\cdot\tilde{H}^s{}_N(Y',C'_1,B',\cdots,C'_T)\cdot x'_j\cdot\overline{y'_j}\cdot\bigcap_l(a'_l\cdot b'_l\cup\overline{a'_l}\cdot\overline{b'_l}\cup\overline{\mu_2{}^s{}_j{}^l})=0$$

.....................

$$\tilde{H}^s{}_N(X',C'_1,\cdots,C'_{T-1},A')\cdot\tilde{H}^s{}_N(Y',C'_1,\cdots,C'_{T-1},B')\cdot x'_j\cdot\overline{y'_j}\cdot\bigcap_l(a'_l\cdot b'_l\cup\overline{a'_l}\cdot\overline{b'_l}\cup\overline{\mu_T{}^s{}_j{}^l})=0$$

to determine values of $\lambda^{ql}_j$ and $\theta^{pl}_{1j}$, $\theta^{pl}_{2j}$ and $\mu^{sl}_{1j}$ to $\mu^{sl}_{Tj}$ such as to reduce variable dependencies of the one or more new operators with inputs and outputs in comparison to the old operation system, and the one or more encoders, one or more decoders and the one or more operators are designed with the determined values, whereby a circuit scale and a delay time of the one or more new operators are reduced.

**12.** The logic function design method of Claim 9, wherein a condition of $\theta^{pl}_{1j}$-$\theta^{pl}_{2j}$ is imposed to aforementioned $\theta^{pl}_{1j}$ and $\theta^{pl}_{2j}$ of the binary operations, or a condition of $\mu^{sl}_{1j}=\cdots=\mu^{sl}_{Tj}$ is imposed to aforementioned $\mu^{sl}_{1j}$ to $\mu^{sl}_{Tj}$ of the T-nary operations to make the binary operations or the T-nary operations of a symmetric type.

**13.** The operation device design method of Claim 3 or Claim 4, wherein space $B_r^n$ of the old representation space $B_r^n$ is same as space $B_r^m$ of the new representation data ($B_r^n = B_r^m, n=m$); the one or more encoders $\Phi$ are isomorphic mappings such as $\Phi : B_r^n \to B_r^n$; and the one ore more decoders $\Psi$ are such as $\Psi=\Phi^{-1}$ (inverse mappings of $\Phi$).

**14.** The operation device design method of Claim 13, wherein:

the one or more encoders are determined to satisfy following expressions (51) and (55) to (57),

(51)
$$\bigcup_Y \overline{\tilde{I}(Z,Y)} \cdot \tilde{\Phi}(Y,X) = \overline{\tilde{\Phi}(Z,X)}$$
$$\bigcup_Y \overline{\tilde{I}(Z,Y)} \cdot \tilde{\Phi}(X,Y) = \overline{\tilde{\Phi}(X,Z)}$$

(55)
$$\tilde{G}^q o(X,A) \cdot \tilde{G}^q o(Y,B) \cdot \phi_j(X) \cdot \overline{\phi_j(Y)} \cdot \bigcap_l (\phi_l(A) \cdot \phi_l(B) \cup \overline{\phi_l(A)} \cdot \overline{\phi_l(B)} \cup \overline{\lambda^q{}_j{}^l}) = 0$$

(56)
$$\tilde{F}^p o(X,A,C) \cdot \tilde{F}^p o(Y,B,C) \cdot \phi_j(X) \cdot \overline{\phi_j(Y)} \cdot \bigcap_l (\phi_l(A) \cdot \phi_l(B) \cup \overline{\phi_l(A)} \cdot \overline{\phi_l(B)} \cup \overline{\theta_1{}^p{}_j{}^l}) = 0$$
$$\tilde{F}^p o(X,C,A) \cdot \tilde{F}^p o(Y,C,B) \cdot \phi_j(X) \cdot \overline{\phi_j(Y)} \cdot \bigcap_l (\phi_l(A) \cdot \phi_l(B) \cup \overline{\phi_l(A)} \cdot \overline{\phi_l(B)} \cup \overline{\theta_2{}^p{}_j{}^l}) = 0$$

(57)
$$\tilde{H}^s o(X,A,C_2,\cdots,C_T) \cdot \tilde{H}^s o(Y,B,C_2,\cdots,C_T) \cdot \phi_j(X) \cdot \overline{\phi_j(Y)} \cdot \bigcap_l (\phi_l(A) \cdot \phi_l(B) \cup \overline{\phi_l(A) \cdot \phi_l(B)} \cup \overline{\mu_1{}^s{}_j{}^l}) = 0$$
$$\tilde{H}^s o(X,C_1,A,\cdots,C_T) \cdot \tilde{H}^s o(Y,C_1,B,\cdots,C_T) \cdot \phi_j(X) \cdot \overline{\phi_j(Y)} \cdot \bigcap_l (\phi_l(A) \cdot \phi_l(B) \cup \overline{\phi_l(A) \cdot \phi_l(B)} \cup \overline{\mu_2{}^s{}_j{}^l}) = 0$$

......................

$$\tilde{H}^s o(X,C_1,C_2,\cdots,A) \cdot \tilde{H}^s o(Y,C_1,C_2,\cdots,B) \cdot \phi_j(X) \cdot \overline{\phi_j(Y)} \cdot \bigcap_l (\phi_l(A) \cdot \phi_l(B) \cup \overline{\phi_l(A) \cdot \phi_l(B)} \cup \overline{\mu_T{}^s{}_j{}^l}) = 0$$

;

the one or more decoders $\Psi$ are determined such as $\Psi=\Phi^{-1}$; and,

the one or more operators of the new operation system are determined under variable dependencies $\lambda^{ql}_{j}$ and $\theta^{pl}_{1j}$, $\theta^{pl}_{2j}$ and $\mu^{sl}_{lj}$ to $\mu^{sl}_{Tj}$ for each new operation system by following expressions (52) to (54),

$$(52)\quad \tilde{G}^{q}{}_{N}(Y',X') = \bigcup_{Y}\bigcup_{X}\tilde{G}^{q}{}_{O}(Y,X)\cdot\tilde{\Phi}(Y',Y)\cdot\tilde{\Phi}(X',X)$$

$$(53)\quad \tilde{F}^{p}{}_{N}(Z',X',Y') = \bigcup_{Z}\bigcup_{X}\bigcup_{Y}\tilde{F}^{p}{}_{O}(Z,X,Y)\cdot\tilde{\Phi}(Z',Z)\cdot\tilde{\Phi}(X',X)\cdot\tilde{\Phi}(Y',Y)$$

$$(54)\quad \tilde{H}^{s}{}_{N}(Y',X'_{1},\cdots,X'_{T}) = \bigcup_{Y}\bigcup_{X_{1}}\cdots\bigcup_{X_{T}}\tilde{H}^{s}{}_{O}(Y,X_{1},\cdots,X_{T})\cdot\tilde{\Phi}(Y',Y)\cdot\tilde{\Phi}(X'_{1},X_{1})\cdots\tilde{\Phi}(X'_{T},X_{T})\ .$$

FIG.1

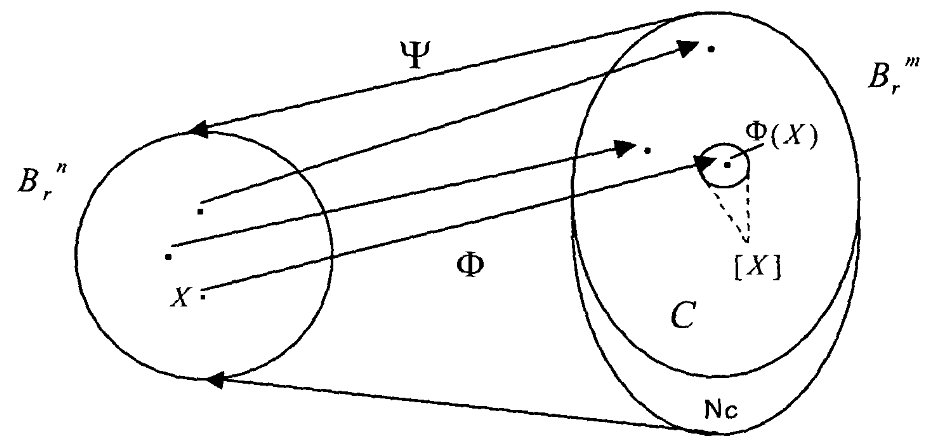


FIG.2

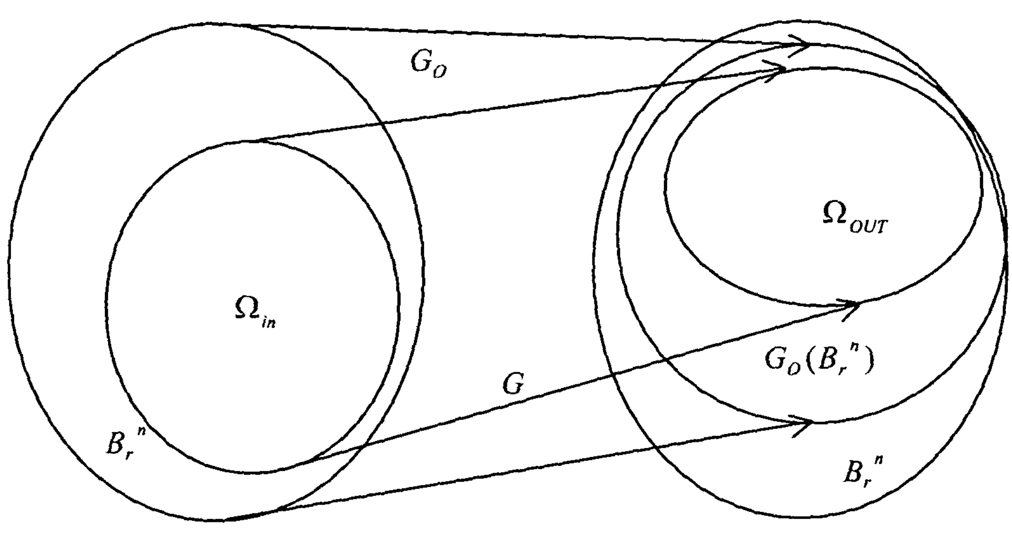

FIG.3

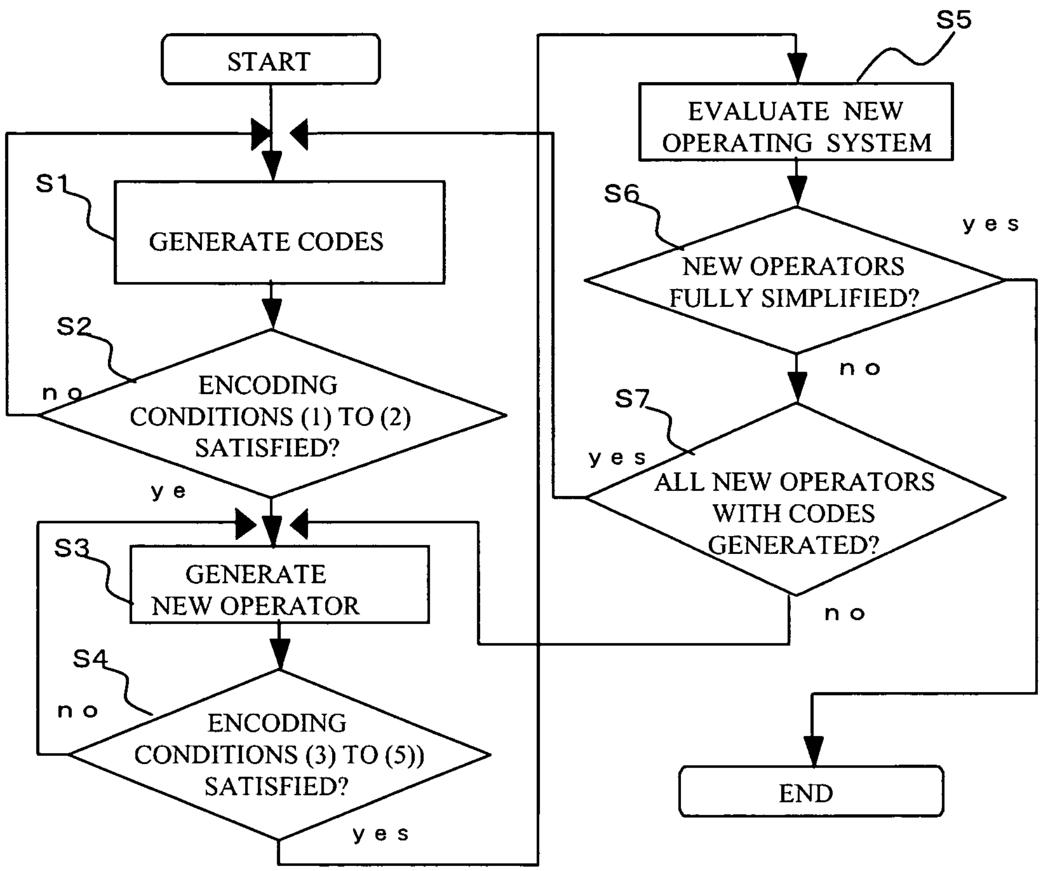
START
S1
GENERATE CODES
S2
ENCODING CONDITIONS (1) TO (2) SATISFIED?
n o
y e
S3
GENERATE NEW OPERATOR
S4
ENCODING CONDITIONS (3) TO (5)) SATISFIED?
n o
y e s
S5
EVALUATE NEW OPERATING SYSTEM
S6
NEW OPERATORS FULLY SIMPLIFIED?
y e s
n o
S7
ALL NEW OPERATORS WITH CODES GENERATED?
y e s
n o
END

FIG.4

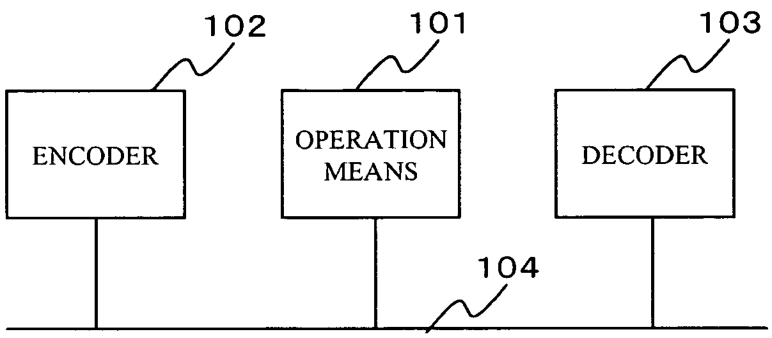


OPERATION DEVICE 100

FIG.5

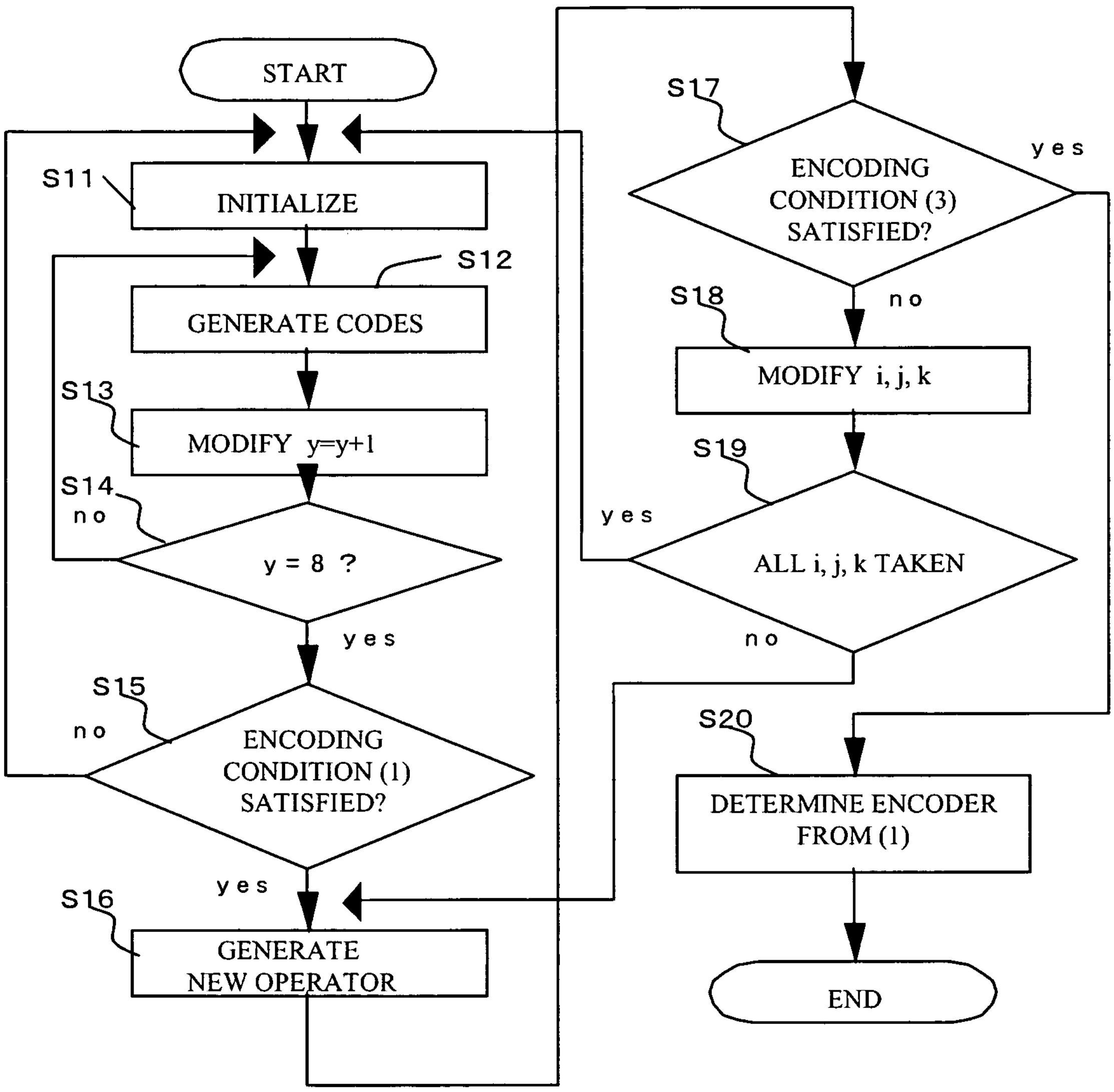
START
S11
INITIALIZE
S12
GENERATE CODES
S13
MODIFY y=y+1
S14
no
y = 8 ?
yes
S15
no
ENCODING CONDITION (1) SATISFIED?
yes
S16
GENERATE NEW OPERATOR
S17
ENCODING CONDITION (3) SATISFIED?
yes
S18
no
MODIFY i, j, k
S19
yes
ALL i, j, k TAKEN
no
S20
DETERMINE ENCODER FROM (1)
END

FIG.6

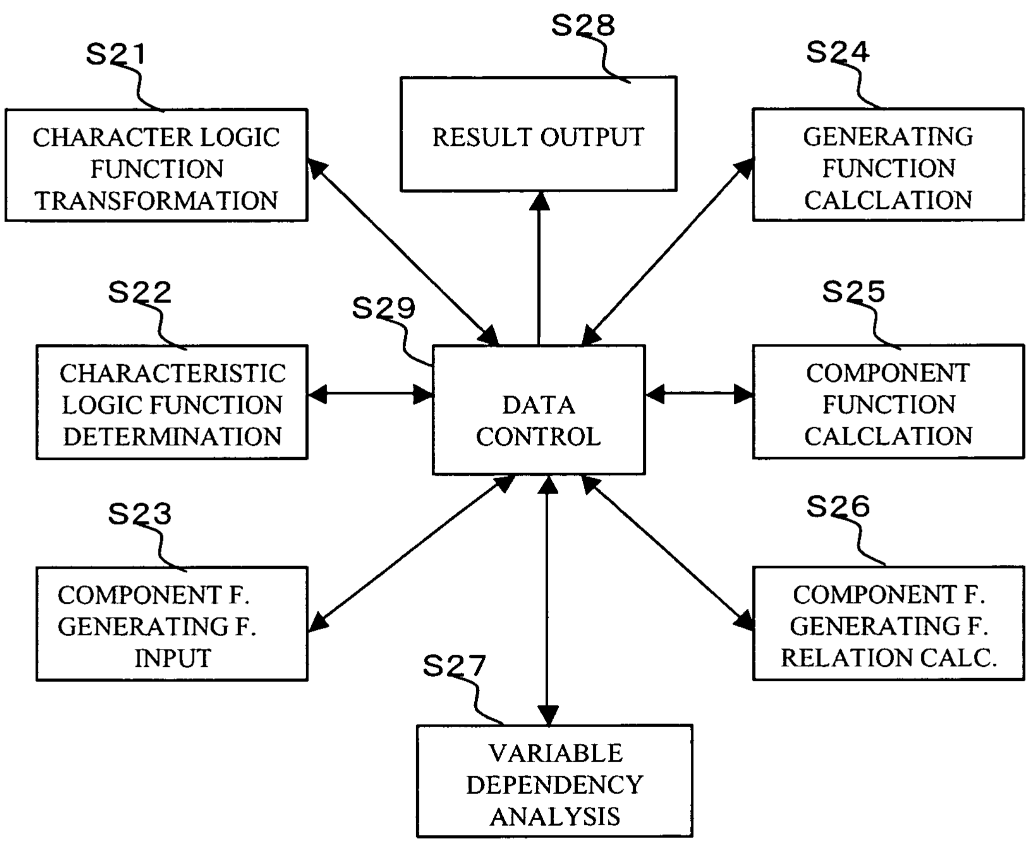
S21
CHARACTER LOGIC FUNCTION TRANSFORMATION
S28
RESULT OUTPUT
S24
GENERATING FUNCTION CALCLATION
S22
CHARACTERISTIC LOGIC FUNCTION DETERMINATION
S29
DATA CONTROL
S25
COMPONENT FUNCTION CALCLATION
S23
COMPONENT F. GENERATING F. INPUT
S26
COMPONENT F. GENERATING F. RELATION CALC.
S27
VARIABLE DEPENDENCY ANALYSIS

# FIG.7

$Z' = F^1(X, Y)$

| X \ Y | 00 | 01 | 10 | 11 |
|---|---|---|---|---|
| 00 | 011 | 110 | 000 | 101 |
| 01 | 110 | 111 | 110 | 110 |
| 10 | 000 | 110 | 000 | 111 |
| 11 | 101 | 110 | 111 | 101 |

# FIG.8

$Z' = F^2(X', Y')$

| X' \ Y | 000 | 001 | 010 | 011 | 100 | 101 | 110 | 111 |
|---|---|---|---|---|---|---|---|---|
| 000 | 010 | 001 | 110 | 100 | 001 | 100 | 110 | 010 |
| 001 | 001 | 011 | 100 | 001 | 100 | 101 | 011 | 101 |
| 010 | 110 | 100 | 010 | 001 | 100 | 001 | 010 | 110 |
| 011 | 100 | 001 | 001 | 100 | 001 | 100 | 001 | 100 |
| 100 | 001 | 100 | 100 | 001 | 100 | 001 | 100 | 001 |
| 101 | 100 | 101 | 001 | 100 | 001 | 011 | 101 | 011 |
| 110 | 110 | 011 | 010 | 001 | 100 | 101 | 000 | 111 |
| 111 | 010 | 101 | 110 | 100 | 001 | 011 | 111 | 000 |

# FIG.9

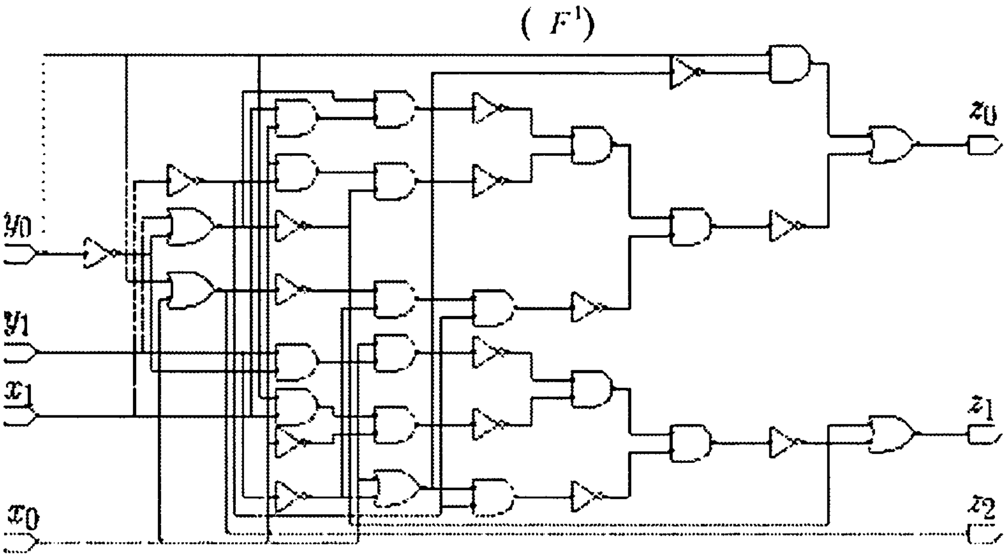

FIG.10

( $F^2$ )

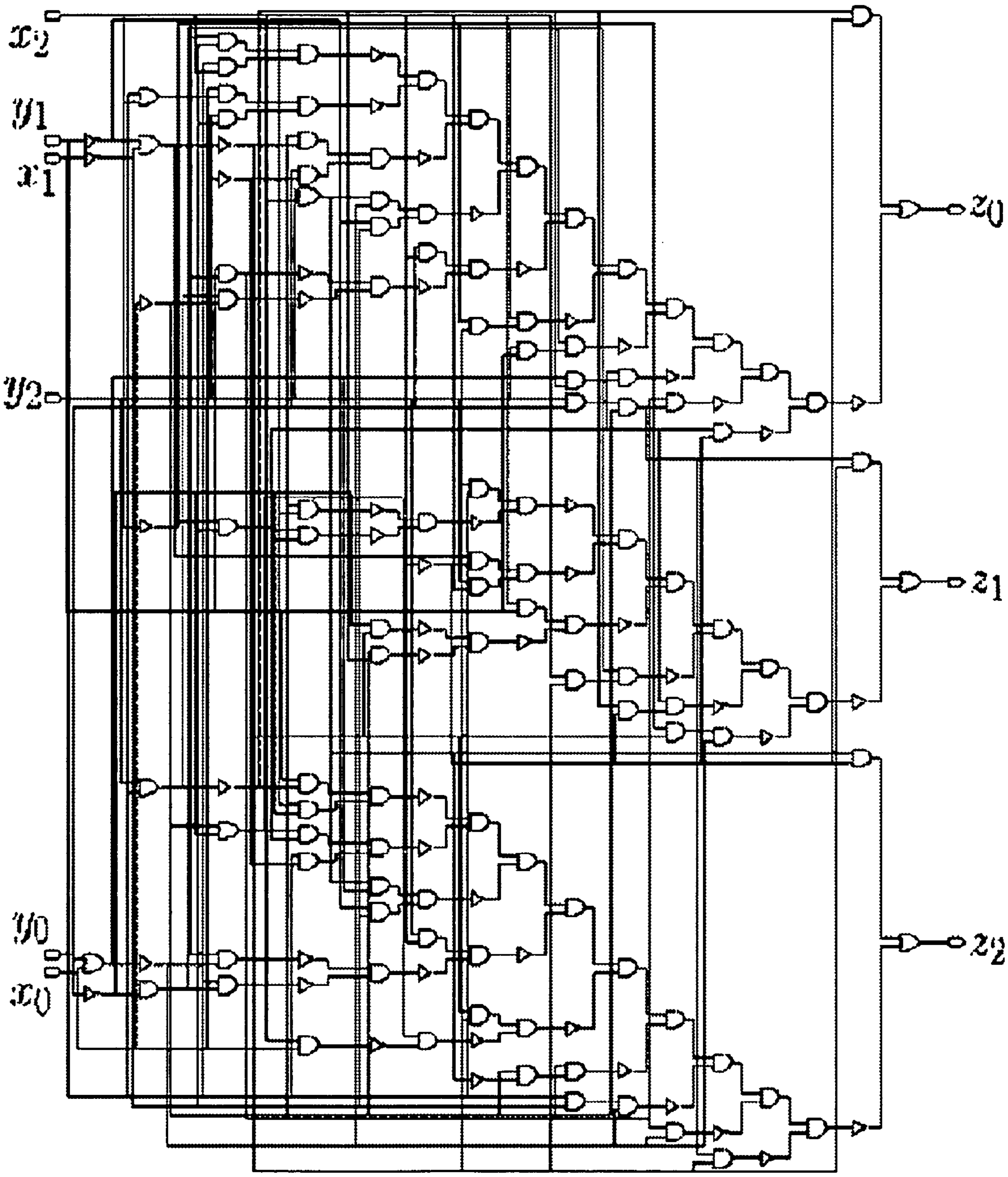

FIG.11

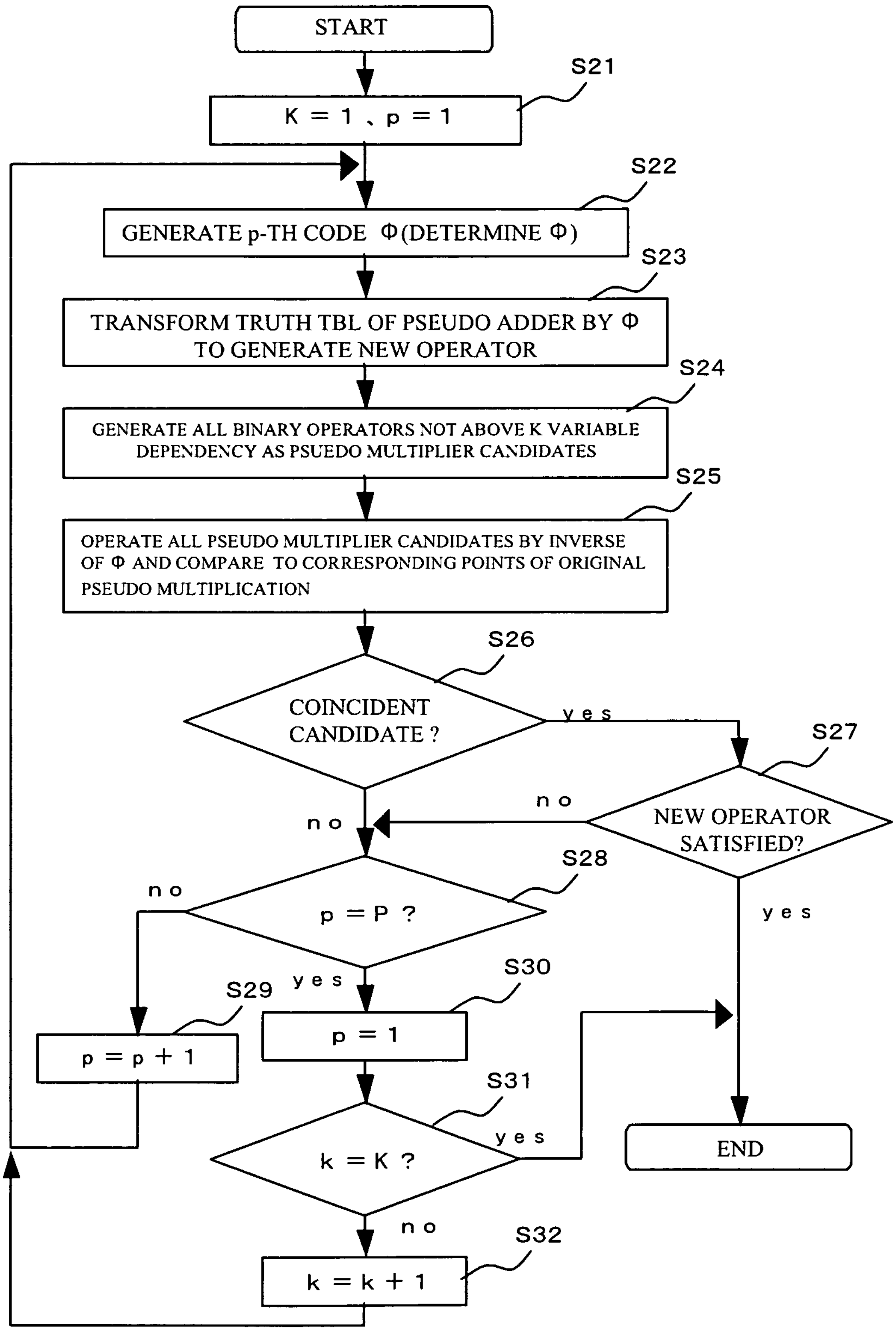
START
S21
K = 1 、p = 1
S22
GENERATE p-TH CODE Φ(DETERMINE Φ)
S23
TRANSFORM TRUTH TBL OF PSEUDO ADDER BY Φ TO GENERATE NEW OPERATOR
S24
GENERATE ALL BINARY OPERATORS NOT ABOVE K VARIABLE DEPENDENCY AS PSUEDO MULTIPLIER CANDIDATES
S25
OPERATE ALL PSEUDO MULTIPLIER CANDIDATES BY INVERSE OF Φ AND COMPARE TO CORRESPONDING POINTS OF ORIGINAL PSEUDO MULTIPLICATION
S26
COINCIDENT CANDIDATE ?
yes
S27
NEW OPERATOR SATISFIED?
no
no
S28
p = P ?
no
yes
S29
p = p + 1
S30
p = 1
yes
S31
k = K ?
yes
END
no
S32
k = k + 1

# FIG.12

$Z' = F'_N(X', Y')$

| X' \ Y' | 000 | 001 | 010 | 011 | 100 | 101 | 110 | 111 |
|---|---|---|---|---|---|---|---|---|
| 000 | 000 | 100 | 000 | 100 | 010 | 110 | 010 | 110 |
| 001 | 100 | 000 | 100 | 000 | 110 | 010 | 110 | 010 |
| 010 | 000 | 100 | 001 | 101 | 010 | 110 | 011 | 111 |
| 011 | 100 | 000 | 101 | 001 | 110 | 010 | 111 | 011 |
| 100 | 010 | 110 | 010 | 110 | 010 | 110 | 010 | 110 |
| 101 | 110 | 010 | 110 | 010 | 110 | 010 | 110 | 010 |
| 110 | 010 | 110 | 011 | 111 | 010 | 110 | 011 | 111 |
| 111 | 110 | 010 | 111 | 011 | 110 | 010 | 111 | 011 |

# FIG.13

| X' | $\Phi(X')$ |
|---|---|
| 000 | 011 |
| 001 | 100 |
| 010 | 111 |
| 011 | 001 |
| 100 | 101 |
| 101 | 000 |
| 110 | 110 |
| 111 | 010 |

FIG.14

$Z' = F^2_N(X', Y')$

| $X'$ \ $Y'$ | 000 | 001 | 010 | 011 | 100 | 101 | 110 | 111 |
|---|---|---|---|---|---|---|---|---|
| 000 | 001 | 101 | 001 | 101 | 000 | 100 | 000 | 100 |
| 001 | 101 | 101 | 101 | 101 | 100 | 100 | 100 | 100 |
| 010 | 001 | 101 | 011 | 111 | 000 | 100 | 010 | 110 |
| 011 | 100 | 000 | 101 | 001 | 110 | 010 | 111 | 011 |
| 100 | 101 | 101 | 111 | 111 | 100 | 100 | 110 | 110 |
| 101 | 100 | 100 | 100 | 100 | 101 | 101 | 101 | 101 |
| 110 | 000 | 100 | 010 | 110 | 001 | 101 | 011 | 111 |
| 111 | 100 | 100 | 110 | 110 | 101 | 101 | 111 | 111 |

FIG.15

| $X'$ | $\Psi(X')$ |
|---|---|
| 000 | 101 |
| 001 | 011 |
| 010 | 111 |
| 011 | 001 |
| 100 | 001 |
| 101 | 100 |
| 110 | 110 |
| 111 | 010 |

FIG.16

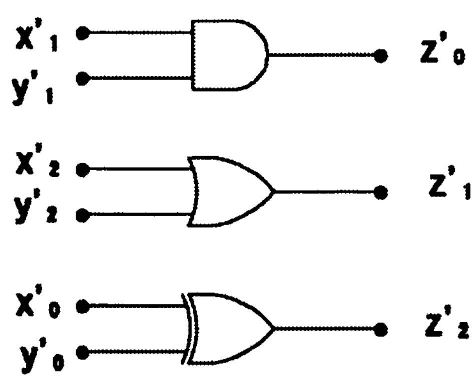

FIG.17

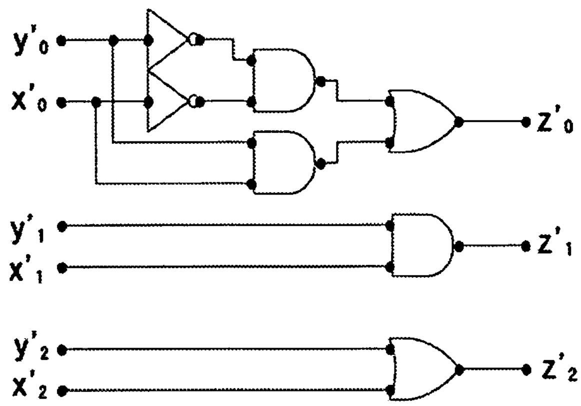


FIG.18

( Φ )

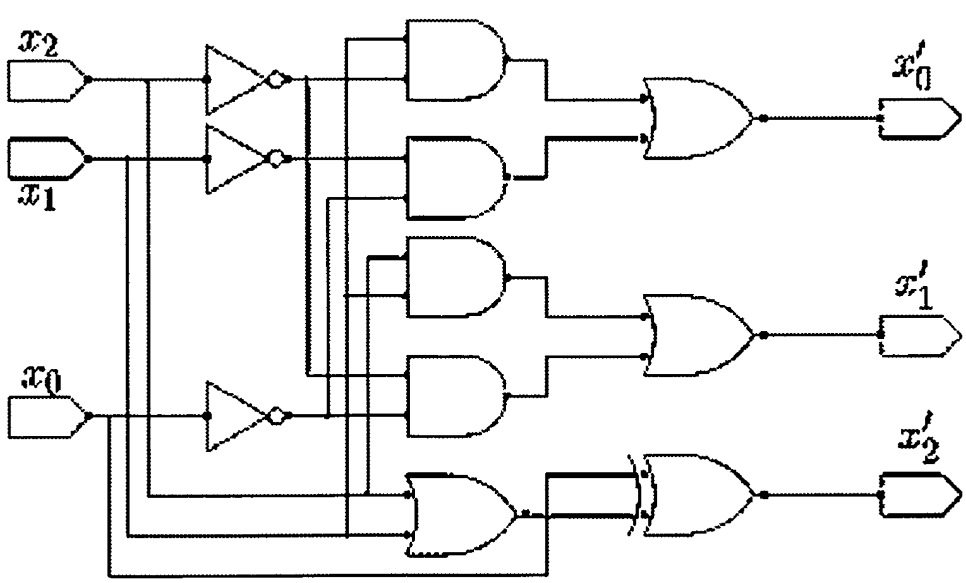

# FIG.19

(Ψ)

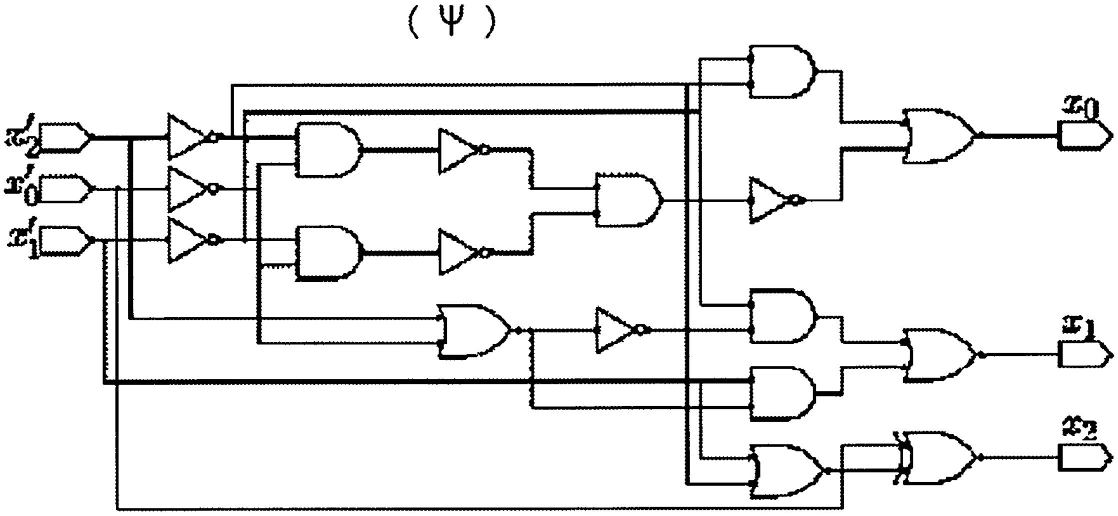


# FIG.20

| | | ELEMENT NUMBER | DELAY TIME |
|---|---|---|---|
| ORIGINAL | $F^1$ | $\square^1 = 57\square$ | $\triangle^1 = 13\triangle$ |
| | $F^2$ | $\square^2 = 267\square$ | $\triangle^2 = 29\triangle$ |
| NEW OPERATION SYS. | $F^1{}_N$ | $\square^1{}_N = 2\square$ | $\triangle^1{}_N = 6\triangle$ |
| | $F^2{}_N$ | $\square^2{}_N = 12\square$ | $\triangle^2{}_N = 5\triangle$ |
| | $\Phi$ | $\square_\Phi = 21\square$ | $\triangle_\Phi = 5\triangle$ |
| | $\Psi$ | $\square_\Psi = 31\square$ | $\triangle_\Psi = 10\triangle$ |

FIG.21

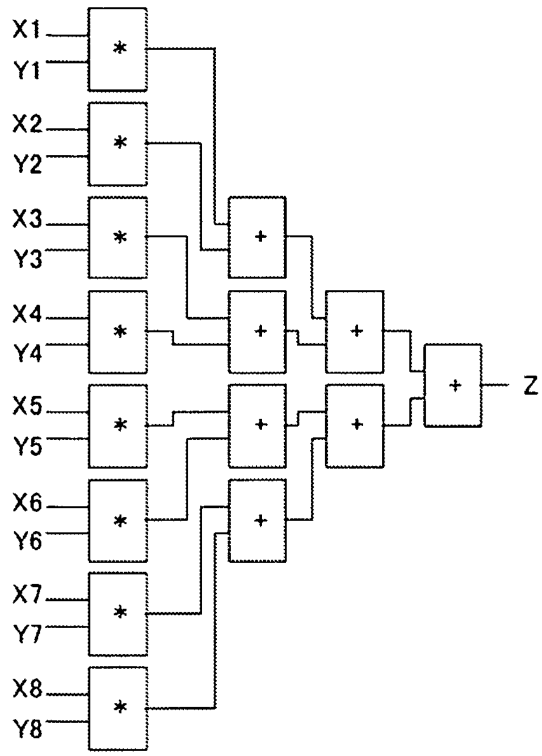
X1
Y1
X2
Y2
X3
Y3
X4
Y4
X5
Y5
X6
Y6
X7
Y7
X8
Y8
*
+
Z

FIG.22

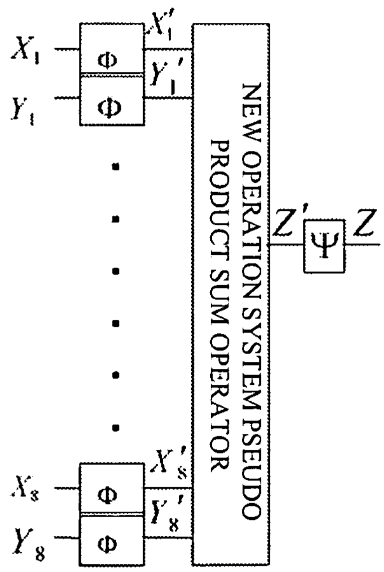
$X_1$
$Y_1$
Φ
$X'_1$
$Y'_1$
$X_8$
$Y_8$
$X'_8$
$Y'_8$
NEW OPERATION SYSTEM PSEUDO PRODUCT SUM OPERATOR
$Z'$
Ψ
$Z$

# FIG.23

| $X$ | $G^1(X)$ |
|---|---|
| 00 | 00 |
| 01 | 00 |
| 10 | 01 |
| 11 | 11 |

| $X$ | $G^2(X)$ |
|---|---|
| 00 | 00 |
| 01 | 00 |
| 10 | 01 |
| 11 | 10 |

# FIG.24

$\tilde{G}^1(Y, X)$

| | $X^0$ | $X^1$ | $X^2$ | $X^3$ |
|---|---|---|---|---|
| $Y^0$ | 1 | 1 | 0 | 0 |
| $Y^1$ | 0 | 0 | 1 | 0 |
| $Y^2$ | 0 | 0 | 0 | 0 |
| $Y^3$ | 0 | 0 | 0 | 1 |

$\tilde{G}^2(Y, X)$

| | $X^0$ | $X^1$ | $X^2$ | $X^3$ |
|---|---|---|---|---|
| $Y^0$ | 1 | 1 | 0 | 0 |
| $Y^1$ | 0 | 0 | 1 | 0 |
| $Y^2$ | 0 | 0 | 0 | 1 |
| $Y^3$ | 0 | 0 | 0 | 0 |

FIG.25

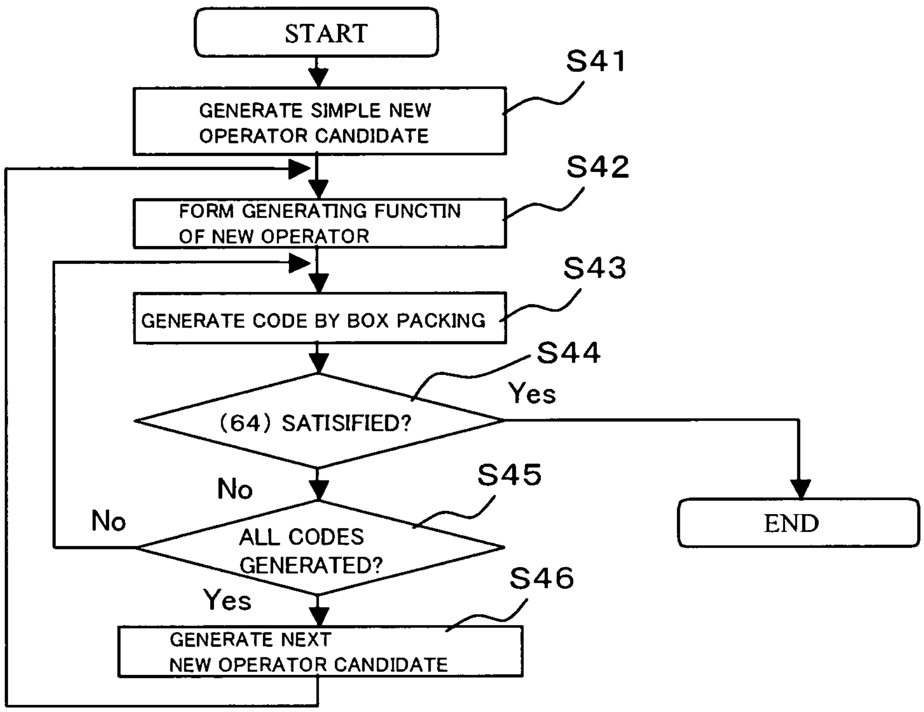
START
S41
GENERATE SIMPLE NEW OPERATOR CANDIDATE
S42
FORM GENERATING FUNCTIN OF NEW OPERATOR
S43
GENERATE CODE BY BOX PACKING
S44
Yes
(64) SATISIFIED?
No
S45
No
ALL CODES GENERATED?
Yes
S46
GENERATE NEXT NEW OPERATOR CANDIDATE
END

FIG.26

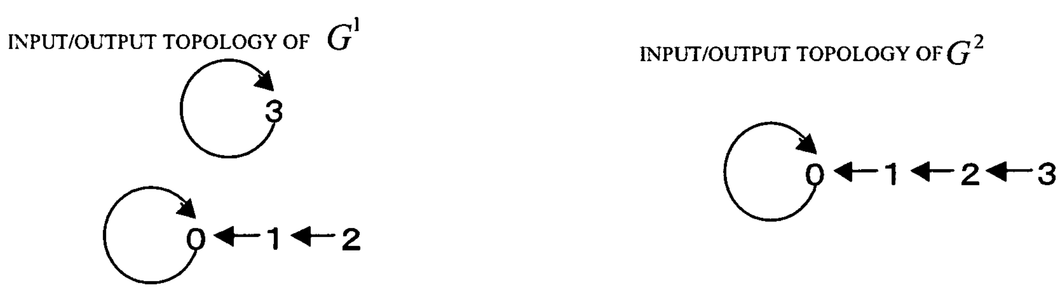
INPUT/OUTPUT TOPOLOGY OF $G^1$
3
0 1 2
INPUT/OUTPUT TOPOLOGY OF $G^2$
0 1 2 3

FIG.27

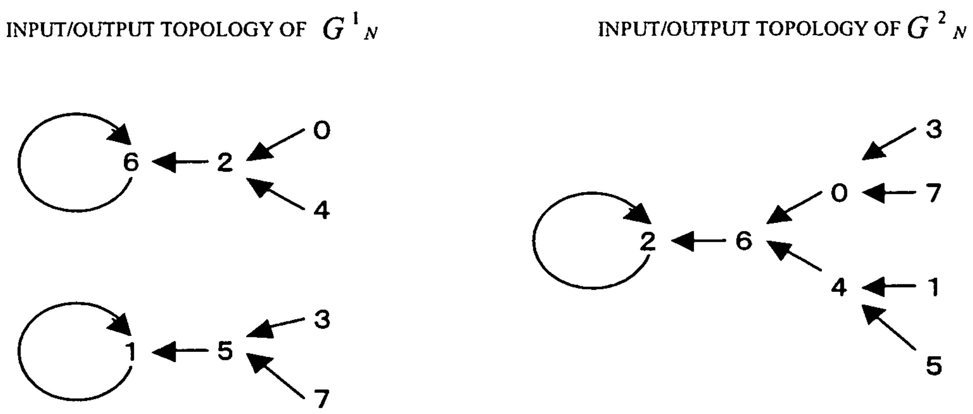
INPUT/OUTPUT TOPOLOGY OF $G^1{}_N$
6
2
0
4
1
5
3
7
INPUT/OUTPUT TOPOLOGY OF $G^2{}_N$
3
0
7
2
6
4
1
5

FIG.28

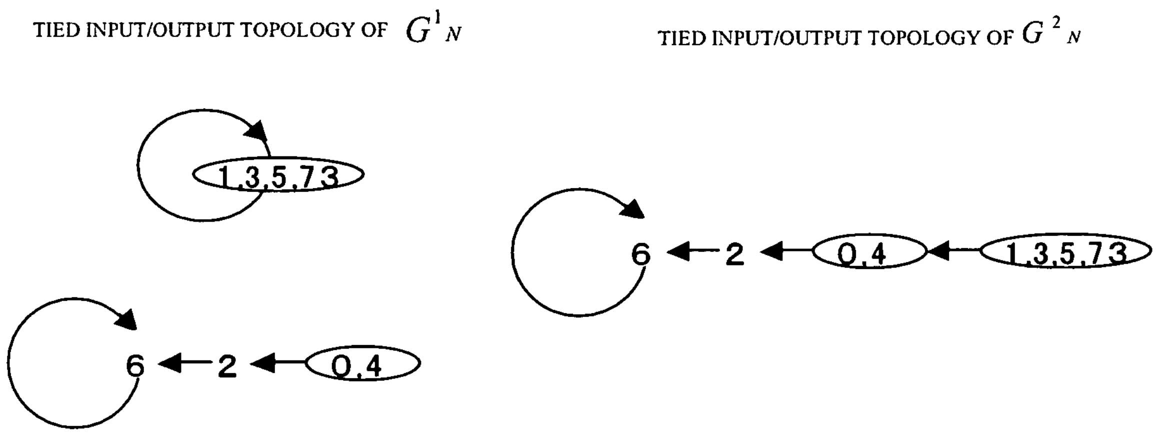
TIED INPUT/OUTPUT TOPOLOGY OF $G^1{}_N$
1,3,5,73
6
2
0,4
TIED INPUT/OUTPUT TOPOLOGY OF $G^2{}_N$
6
2
0,4
1,3,5,73

FIG.29

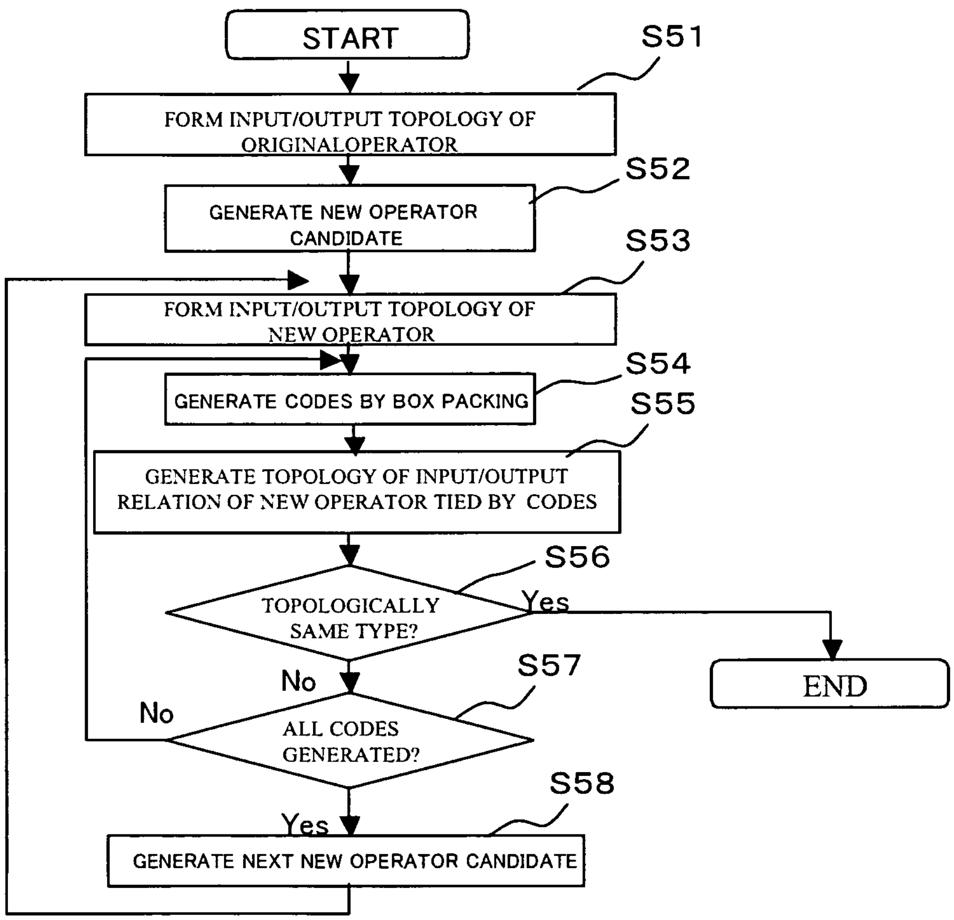
START
S51
FORM INPUT/OUTPUT TOPOLOGY OF ORIGINALOPERATOR
S52
GENERATE NEW OPERATOR CANDIDATE
S53
FORM INPUT/OUTPUT TOPOLOGY OF NEW OPERATOR
S54
GENERATE CODES BY BOX PACKING
S55
GENERATE TOPOLOGY OF INPUT/OUTPUT RELATION OF NEW OPERATOR TIED BY CODES
S56
TOPOLOGICALLY SAME TYPE?
Yes
END
No
S57
No
ALL CODES GENERATED?
S58
Yes
GENERATE NEXT NEW OPERATOR CANDIDATE

## INTERNATIONAL SEARCH REPORT

International application No. PCT/JP2004/000640

**A. CLASSIFICATION OF SUBJECT MATTER**
Int.Cl[7] G06F17/10, G06F17/50

According to International Patent Classification (IPC) or to both national classification and IPC

**B. FIELDS SEARCHED**

Minimum documentation searched (classification system followed by classification symbols)
Int.Cl[7] G06F17/00-17/18, G06F17/50, G06F7/38-7/54

Documentation searched other than minimum documentation to the extent that such documents are included in the fields searched

| | | | |
|---|---|---|---|
| Jitsuyo Shinan Koho | 1922-1996 | Toroku Jitsuyo Shinan Koho | 1994-2004 |
| Kokai Jitsuyo Shinan Koho | 1971-2004 | Jitsuyo Shinan Toroku Koho | 1996-2004 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 03-201114 A (Shuji WATARI), 03 September, 1991 (03.09.91), Full text; all drawings & WO 91/10186 A1 & EP 507946 A1 | 1,2 |

☐ Further documents are listed in the continuation of Box C.  ☐ See patent family annex.

* Special categories of cited documents:
"A" document defining the general state of the art which is not considered to be of particular relevance
"E" earlier document but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| | |
|---|---|
| Date of the actual completion of the international search<br>15 March, 2004 (15.03.04) | Date of mailing of the international search report<br>30 March, 2004 (30.03.04) |
| Name and mailing address of the ISA/<br>Japanese Patent Office | Authorized officer |
| Facsimile No. | Telephone No. |

Form PCT/ISA/210 (second sheet) (July 1998)

**INTERNATIONAL SEARCH REPORT**

International application No.
PCT/JP2004/000640

**Box I Observations where certain claims were found unsearchable (Continuation of item 2 of first sheet)**

This international search report has not been established in respect of certain claims under Article 17(2)(a) for the following reasons:

1. [X] Claims Nos.: 3-14
   because they relate to subject matter not required to be searched by this Authority, namely:
   Claims 3 to 14 relate to scientific and mathematical theories and do not require search by the International Search Authority under the provisions of PCT Article 17(2)(a)(i) and PCT Rule 39.1(i).

2. [ ] Claims Nos.:
   because they relate to parts of the international application that do not comply with the prescribed requirements to such an extent that no meaningful international search can be carried out, specifically:

3. [ ] Claims Nos.:
   because they are dependent claims and are not drafted in accordance with the second and third sentences of Rule 6.4(a).

**Box II Observations where unity of invention is lacking (Continuation of item 3 of first sheet)**

This International Searching Authority found multiple inventions in this international application, as follows:

1. [ ] As all required additional search fees were timely paid by the applicant, this international search report covers all searchable claims.

2. [ ] As all searchable claims could be searched without effort justifying an additional fee, this Authority did not invite payment of any additional fee.

3. [ ] As only some of the required additional search fees were timely paid by the applicant, this international search report covers only those claims for which fees were paid, specifically claims Nos.:

4. [ ] No required additional search fees were timely paid by the applicant. Consequently, this international search report is restricted to the invention first mentioned in the claims; it is covered by claims Nos.:

**Remark on Protest** [ ] The additional search fees were accompanied by the applicant's protest.
[ ] No protest accompanied the payment of additional search fees.

Form PCT/ISA/210 (continuation of first sheet (1)) (July 1998)